(19) **Europäisches Patentamt / European Patent Office / Office européen des brevets**

(11) **EP 4 708 361 A1**

(12) **EUROPEAN PATENT APPLICATION**
published in accordance with Art. 153(4) EPC

(43) Date of publication:
11.03.2026  Bulletin 2026/11

(21) Application number: 24870263.1

(22) Date of filing: 23.08.2024

(51) International Patent Classification (IPC):
H01L 23/66 (2006.01)       H01L 23/31 (2006.01)
H01Q 1/22 (2006.01)        H01P 3/123 (2006.01)

(52) Cooperative Patent Classification (CPC):
H01P 3/123; H01Q 1/22; H10W 44/20; H10W 74/10

(86) International application number:
PCT/CN2024/114349

(87) International publication number:
WO 2025/066717 (03.04.2025 Gazette 2025/14)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 28.09.2023  CN 202322672173 U
12.12.2023  CN 202323391601 U
08.05.2024  CN 202410566287

(71) Applicant: Calterah Semiconductor Technology (Shanghai) Co., Ltd.
Shanghai 201210 (CN)

(72) Inventors:
• CHEN, Zhefan
  Shanghai 201210 (CN)
• HUANG, Xuejuan
  Shanghai 201210 (CN)
• WANG, Dian
  Shanghai 201210 (CN)
• LI, Shan
  Shanghai 201210 (CN)
• ZHUANG, Kaijie
  Shanghai 201210 (CN)
• YU, Chenwu
  Shanghai 201210 (CN)

(74) Representative: Murgitroyd & Company
165-169 Scotland Street
Glasgow G5 8PL (GB)

(54) **RADIO-FREQUENCY APPARATUS, RADIO-FREQUENCY TRANSMISSION SYSTEM, RADIO-FREQUENCY SYSTEM, RADIO-FREQUENCY MODULE, AND RADAR**

(57) Provided are a radio-frequency apparatus, a radio-frequency transmission system, a radio-frequency system, a radio-frequency module, and a radar. The radio-frequency apparatus comprises a packaging body (11) in which an IC bare die is packaged, and a PCB (21), wherein on the surface of the packaging body (11), at least one radiation sheet (119) and a plurality of solder balls (12), which are respectively arranged around each radiation sheet into a circle and form a waveguide channel, are provided, and an inner ring enclosed by the plurality of solder balls (12) comprises at least one ridge portion (121), which protrudes towards the inside of the ring; and the PCB (21) is provided with a first waveguide hole (211), which has the same shape as the inner ring enclosed by the solder balls (12). The radio-frequency transmission system further comprises a waveguide structure (22), which is arranged on the side of the PCB (21) that is away from the packaging body (11), wherein the waveguide structure (22) is provided with a ridge-shaped or rectangular second waveguide hole (221). The radio-frequency apparatus reduces the area occupied by a packaging transition structure, the radio-frequency transmission system realizes the diversification of a radio-frequency signal transmission channel, and the radio-frequency module reduces the loss.

**(Cont. next page)**

FIG. 2

## Description

This application claims priority to Chinese Patent Application No.202322672173.5 filed on September 28, 2023 and entitled "Radio-frequency apparatus and Radar apparatus", Chinese Patent Application No. 202323391601.3 filed on December 12, 2023 and entitled "Radio-frequency transmission system and Radio-frequency system", and Chinese Patent Application No. 202410566287.8 filed on May 8, 2024 and entitled "Radio-frequency Module, Radar and Electronic Device", contents of which should be construed as being incorporated into the present application by reference.

Technical field

The present application relates to, but is not limited to, semiconductor radio frequency technology, in particular to a radio-frequency apparatus, a radio-frequency transmission system, a radio-frequency system, a radio-frequency module, and a radar.

Background

In the semiconductor industry, conversion from chip packaging to waveguide is a complex technology, commonly used for high-frequency high-speed signal transmission or high-frequency radio frequency applications. The technology of the conversion from chip packaging to waveguide involves the following actions: a signal on the chip is transferred to the waveguide or microstrip line by using a special package or connection structure to achieve better signal transmission performance and frequency response; a Radio Frequency (RF) signal from a die first enters the chip package, and then is converted to an external waveguide/microstrip line/coaxial line or another transmission structure by the connection structure. A waveguide is a structure used to transmit electromagnetic waves, usually applied to high-frequency and high-speed signal transmission or high-frequency radio frequency applications. The waveguide may be a hollow metal conduit or a dielectric conduit used to guide propagation of electromagnetic waves such as microwaves, millimeter waves, or light waves.

In a package transition structure where the radio-frequency signal in the chip packaging is converted to an externally connected waveguide, on the premise of ensuring low loss and wide impedance bandwidth characteristics, it is also urgent to solve a problem of how to reduce an area occupied by the package transition structure.

Summary

In order to solve the above technical problems, an embodiment of the present application provides a radio-frequency apparatus including a packaging body in which an Integrated Circuit (IC) die is packaged; a surface of the packaging body is provided with at least one radiation portion, and the radiation portion is connected to the IC die to perform a signal transmission.

A plurality of solder balls respectively disposed around a circumference of the at least one radiation portion, are further provided on the surface of the packaging body, and the plurality of solder balls constitute a waveguide channel for the at least one radiation portion to perform the signal transmission; an inner ring enclosed by the plurality of solder balls includes a ridge portion protruding inwards.

In an exemplary embodiment, further including a Printed Circuit Board (PCB); waveguide holes are respectively provided on the PCB at positions corresponding to respective radiation portions, the packaging body is mounted on the PCB, and a plurality of solder balls are arranged around a boundary of a waveguide hole into a ring.

In an exemplary embodiment, a shape of a cross section of the waveguide hole is the same as a shape of an inner ring enclosed by a plurality of solder balls around the radiation portion.

In an exemplary embodiment, the inner ring is a rectangular ring in which the ridge portion is provided, a circular ring in which the ridge portion is provided, or an elliptical ring in which the ridge portion is provided.

In an exemplary embodiment, the inner ring is a rectangular ring in which the ridge portion is provided;

there is one ridge portion; and the ridge portion is located at a middle of one side or a corner of the rectangular inner ring; or

there are two ridge portions, and the two ridge portions are respectively located at middles of two opposite sides or two opposite corners of the rectangular inner ring.

An embodiment of the present application provides a radio-frequency transmission system, including:

a PCB having a second surface and a third surface which are opposite, wherein at least one first waveguide hole is provided on the PCB, and the at least one first waveguide hole is a ridge-shaped waveguide hole;

a waveguide structure having a fourth surface and a fifth surface which are opposite, wherein on the fourth surface, a second waveguide hole is provided at a position corresponding to each first waveguide hole, and the first waveguide hole is in communication with the second waveguide hole to form a channel for transmitting a radio-frequency signal.

In an exemplary embodiment, the second waveguide hole is a ridge-shaped waveguide hole or a rectangular waveguide hole.

In an exemplary embodiment, the ridge-shaped waveguide hole is a single-ridge waveguide hole or a double-ridge waveguide hole.

In an exemplary embodiment, the fourth surface is docked with the PCB, and an isolation structure is provided on the fourth surface.

In an exemplary embodiment, the isolation structure includes a plurality of protrusion structures which are periodically arranged.

In an exemplary embodiment, a height of a protrusion structure is 1/4 wavelength of the radio-frequency signal, and a distance between two adjacent protrusion structures is 1/6 wavelength to 1/2 wavelength of the radio-frequency signal.

In an exemplary embodiment, the isolation structure includes first protrusion structures at strongest signal field regions at edges of respective second waveguide holes; the isolation structure further includes at least one second protrusion structure disposed around a first protrusion structure, and the first protrusion structure has a cross-sectional diameter greater than or equal to a cross-sectional diameter of the second protrusion structure.

In an exemplary embodiment, a height of the second protrusion structure is 1/4 wavelength of the radio-frequency signal, and a diameter of the second protrusion structure is 1/10 wavelength to 1/3 wavelength of the radio-frequency signal.

In an exemplary embodiment, a gap between upper surfaces of the first protrusion structure and the second protrusion structure and the third surface does not exceed 400 $\mu$m.

In an exemplary embodiment, a distance between the first protrusion structure and an adjacent second protrusion structure is [1/6 $\lambda$, 1/2 $\lambda$], wherein $\lambda$ is an operating wavelength of the radio-frequency signal.

In an exemplary embodiment, the first protrusion structure and the second protrusion structure are in a shape of at least one of a cuboid, a cylinder and a frustum.

In an exemplary embodiment, at least one antenna unit is provided on the fifth surface, and the second waveguide hole is in communication with the antenna unit from an end of a wide side surface of the antenna unit or a middle position of a wide side surface.

In an exemplary embodiment, the second waveguide hole includes two cavity segments which have rectangular cross-sections, and a stepped transition structure is provided at a junction between adjacent cavity segments.

In an exemplary embodiment, the second waveguide holes are arranged in an array, and long sides of two adjacent second waveguide holes are perpendicular to each other.

In an exemplary embodiment, the antenna unit includes a plurality of radiation slots for transmitting and/or receiving the radio-frequency signal.

An embodiment of the present application provides a radio-frequency system including: a packaging body, and the radio-frequency transmission system as described in any one of the above embodiments.

At least one radiation portion is provided on a first surface of the packaging body, a plurality of solder balls are provided on the first surface, and the plurality of solder balls are disposed around the radiation portion to form a first waveguide channel.

The first surface of the packaging body is mounted on the second surface of the PCB, and radiation portions are disposed in one-to-one correspondence with first waveguide holes, respectively.

In an exemplary embodiment, the package including a substrate and an IC die; a surface of the substrate away from the IC die is the first surface, a radio frequency RF trace is provided inside the substrate, and the radio-frequency signal is transmitted to the radiation portion via the RF trace.

In an exemplary embodiment, the substrate includes a metal ground layer, a feeder layer, a patch layer; the RF trace is disposed in the feeder layer, and the radiation portion is disposed in the patch layer; the radio-frequency signal is coupled to the radiation portion through the RF trace.

An embodiment of the present application provides a radar including the radio-frequency apparatus of any one of the above embodiments, or the radio-frequency transmission system of any one of the above embodiments, or the radio-frequency system of any one of the above embodiments.

An embodiment of the present application provides an electronic device, including the above-described radar.

Other features and advantages of the present application will be set forth in the description which follows, and in part will be obvious from the description, or may be learned by practice of the present application. Purposes and other advantages of the present application may be achieved and acquired by the structures particularly pointed out in the description, claims and drawings.

Brief Description of Drawings

Accompanying drawings are used to provide a further understanding of technical solutions of the present application, and constitute a part of the specification. They are used together with the embodiments of the present application to explain the technical solutions of the present application, and do not constitute a limitation on the technical solutions of the present application.

FIG. 1 is a front perspective view of a radio-frequency apparatus according to an embodiment of the present application.

FIG. 2 is a top perspective view of a radio frequency apparatus according to an embodiment of the present application.

FIG. 3 is a schematic top view of a first arrangement of a plurality of solder balls according to an embodiment of the present application.

FIG. 3a is a schematic top view of an arrangement of a plurality of solder balls in the existing art.

FIG. 4 is a schematic top view of a second arrangement of a plurality of solder balls according to an embodiment of the present application.

FIG. 5 is a schematic top view of a third arrangement of a plurality of solder balls according to an embodiment of the present application.

FIG. 6 is a schematic top view of a fourth arrangement of a plurality of solder balls according to an embodiment of the present application.

FIG. 7 is a schematic top view of a first metal layer according to an embodiment of the present application.

FIG. 8 is a schematic top view of a second metal layer according to an embodiment of the present application.

FIG. 9 is a schematic top view of a third metal layer according to an embodiment of the present application.

FIG. 10 is a schematic top view of a plurality of shielding metallization vias according to an embodiment of the present application.

FIG. 11 is a schematic top view of a PCB board according to an embodiment of the present application.

FIG. 12 is a schematic diagram of a form of an RF trace on a second metal layer according to an embodiment of the present application.

FIG. 13 is a schematic diagram of another form of an RF trace on the second metal layer according to an embodiment of the present application.

FIG. 14 is a schematic diagram of still another form of an RF trace on the second metal layer according to an embodiment of the present application.

FIG. 15 is a schematic diagram of RF performance from a substrate to a PCB according to an embodiment of the present application.

FIG. 16 is a schematic diagram of a radio-frequency transmission system according to an embodiment of the present application.

FIG. 17 is a schematic plan view of a docking surface between a PCB board and a waveguide structure according to an embodiment of the present application.

FIG. 18 is a schematic diagram of a radio-frequency transmission system with an isolation structure according to an embodiment of the present application.

FIG. 19 is a schematic plan view of the isolation structure of FIG. 18 on a docking surface between a PCB board and a waveguide structure.

FIG. 20 is a schematic plan view of an isolation structure on a docking surface between a PCB board and a waveguide structure according to an embodiment of the present application.

FIG. 21 is a schematic diagram of another radio-frequency transmission system with an isolation structure according to an embodiment of the present application.

FIG. 22 is a schematic diagram of yet another radio-frequency transmission system with an isolation structure according to an embodiment of the present application.

FIG. 23 is a schematic diagram of still yet another radio-frequency transmission system with an isolation structure according to an embodiment of the present application.

FIG. 24 is a schematic diagram of further still yet another radio-frequency transmission system with an isolation structure according to an embodiment of the present application.

FIG. 25 is a schematic plan view of the isolation structure of FIG. 24 on a docking surface between a PCB board and a waveguide structure.

FIG. 26 is a schematic plan view of another isolation structure on a docking surface between a PCB board and a waveguide structure according to an embodiment of the present application.

FIG. 27 is a schematic plan view of yet another isolation structure on a docking surface between a PCB board and a waveguide structure according to an embodiment of the present application.

FIG. 28 is a schematic plan view of still yet another isolation structure on a docking surface between a PCB board and a waveguide structure according to an embodiment of the present application.

FIG. 29 is a schematic plan view of further still yet another isolation structure on a docking surface between a PCB board and a waveguide structure according to an embodiment of the present application.

FIG. 30 is a schematic plan view of a second waveguide hole on a docking surface between a PCB board and a waveguide structure according to an embodiment of the present application.

FIG. 31 is a schematic plan view of an isolation structure on a docking surface between a PCB board and a waveguide structure according to an embodiment of the present application.

FIG. 32 is a schematic diagram of RF transmission performance parameters corresponding to a radio-frequency transmission system according to the embodiment of the present application.

FIG. 33 is a cross-sectional view of a radio-frequency module in the related art.

FIG. 34 is a cross-sectional view of a radio-frequency module according to an embodiment of the present application.

FIG. 35 is a cross-sectional view of a connection between a substrate and a PCB board according to an embodiment of the present application.

FIG. 36 is a top view of a connection between a substrate and solder balls according to an embodiment of the present application.

FIG. 37 is a top view of connections among a substrate, solder balls, and a PCB board according to an embodiment of the present application.

FIG. 38 is a top view of a PCB board according to an embodiment of the present application.

FIG. 39 is a top view of a waveguide antenna according to an embodiment of the present application.

FIG. 40 is a schematic diagram of connection modes between feeder lines and antenna units according to an embodiment of the present application.

FIG. 41 is a schematic diagram of a layout of feeder lines and antenna units according to an embodiment of the present application.

FIG. 42 is a schematic diagram of a double-layer structure of a waveguide antenna according to an embodiment of the present application.

FIG. 43 is a schematic diagram of stepped transition structures according to an embodiment of the present application.

Detailed Description

In order to make purposes, technical solutions and advantages of the present application clearer, the embodiments of the present application will be described in detail below with reference to the accompanying drawings. It should be noted that the embodiments in the present application and features in the embodiments can be arbitrarily combined with each other if there is not conflict.

In order to facilitate understanding the present application, the present application will be described more fully below with reference to the accompanying drawings. Embodiments of the present application are provided by the accompanying drawings. However, the present application may be implemented in many different forms and is not limited to the embodiments described herein. Rather, these embodiments are provided for the purpose of making the disclosure of the present application more thorough and comprehensive.

Unless otherwise defined, all technical and scientific terms used herein have the same meaning as that commonly understood by those skilled in the art belonging to the present application. The terms used herein in the specification of the present application is for the purpose of describing specific embodiments only, and is not intended to limit the present application.

It may be understood that the terms "first" and "second" used in the present application are for descriptive purposes only and cannot be understood as indicating or implying relative importance or implicitly indicating the quantity of technical features indicated. Thus, a feature defined with "first", "second" may explicitly or implicitly includes at least one of the features. In the description of the present application, "a plurality" means at least two, for example, two, three, etc. unless otherwise explicitly and specifically defined.

It can be understood that "connection" in the following embodiments should be understood as "electrical connection", "communication connection", or the like if connected circuits, modules, units, and the like have transmissions of electrical signals or data between each other.

As used herein, the singular forms "a", "one", and "the/said" may also include plural forms unless the context clearly dictates otherwise. It should also be understood that the terms "including/including" or "having" and the like specify the presence of the stated features, integers, steps, operations, components, portions, or combinations thereof, but do not exclude the possibility of the presence or addition of one or more other features, integers, steps, operations, components, portions, or combinations thereof. Meanwhile, the term "and/or" as used in this specification includes any and all combinations of relevant listed items.

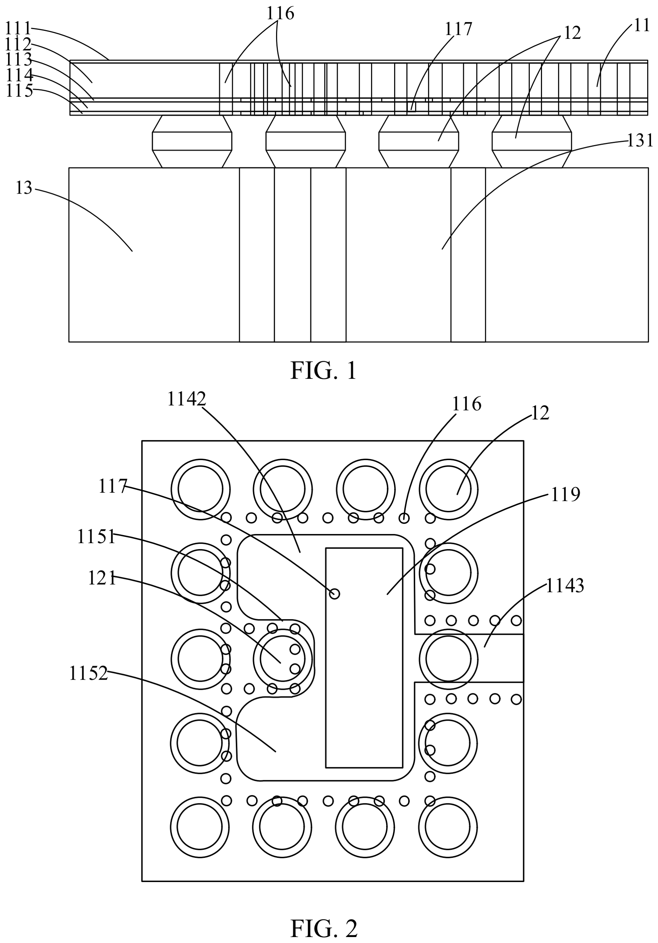

As shown in FIGs. 1 and 2, FIGs. 1 and 2 show a structure of a radio-frequency apparatus in the present embodiment. The radio-frequency apparatus includes a packaging body 11.

An Integrated Circuit (IC) die (not shown) is packaged in the packaging body 11. At least one radiation sheet 119 is provided on a surface of the packaging body 11, and the radiation sheets 119 are electrically connected to an IC die, respectively. A plurality of solder balls 12 are further provided on the surface of the packaging body 11, the plurality of solder balls 12 and the at least one radiation sheet 119 are provided on the surface of the packaging body 11 on the same side, and each radiation sheet 119 is enclosed by a ring of solder balls 2, respectively.

In one exemplary example, a solder ball 12 is made of a metal material and may be configured in a shape of a drum or ball. In one embodiment, the solder ball 12 may be a Ball Grid Array package (BGA) solder ball.

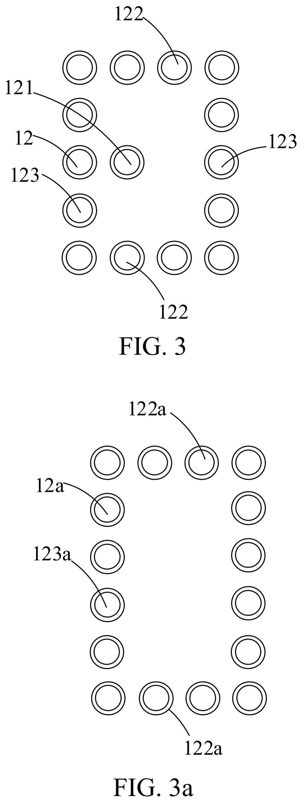

In an exemplary example, as shown in FIGs. 2 and 3, a plurality of solder balls 12 are disposed around a circumference of a radiation sheet 119, and two adjacent solder balls 12 may be spaced apart. The solder balls 12 and the radiation sheets 119 are spaced apart. An inner ring enclosed by the plurality of solder balls 12 includes at least one ridge portion 121 protruding towards the inside of the ring, so that the plurality of solder balls 12 are arranged in a shape of a ridge. Each ridge portion 121 is formed by one or more solder balls 12, and in the present embodiment, the ridge portion 121 is formed by one solder ball 12. The plurality of solder balls 12 enclosing the circumference of the radiation sheet 119 together form a waveguide channel through which the radiation sheet 119 transmits signals.

In one embodiment, the signal transmitted by the IC die is transmitted to each radiation sheet 119, and the radiation sheet 119 then radiates the signal into the waveguide channel enclosed by the plurality of solder balls 12, the signal may be a radio-frequency signal, and the waveguide channel composed of the plurality of solder balls 12 then transmits the signal into a waveguide structure of another component (for example, the waveguide structure may be a waveguide hole 131 of the printed circuit board (PCB) 13 shown in FIG. 1).

In one embodiment, the signal may also be transmitted from the waveguide structure of the above-mentioned component (for example, the waveguide hole 131 of the PCB board 13) to the waveguide channel formed by the plurality of solder balls 12, the waveguide channel then transmits the signal to the radiation sheet 119, and the radiation sheet 119 transmits the signal to the IC die.

In the embodiment of the present application, since the inner ring enclosed by the plurality of solder balls 12 is provided with a ridge portion 121 protruding toward the inner ring, a cavity enclosed by the plurality of solder balls forms a ridge-shaped waveguide cavity.

Herein, the ridge-shaped waveguide cavity can be understood as a cavity which is formed by bending the original rectangular waveguide cavity into the cavity, and after bending, a length of the longest side of the cavity is unchanged, so the transmission performance is unchanged, but after the cavity is bent, an area occupied by the cavity can be reduced, and the number of solder balls surrounding the cavity can also be reduced, thus ensuring that the performance will not be reduced when a plurality of solder balls are used for the radiation sheet to transmit signals.

As an example, FIG. 3a shows an arrangement of solder balls 12a in an existing art, in which a plurality of solder balls 12a are arranged in a rectangle, the lateral side 122a thereof is formed by arranged four solder balls 12a, and the longitudinal side 123a thereof is formed by arranged six solder balls 12a.

In an exemplary example, as shown in FIG. 3, in an arrangement of the solder balls 12 in the embodiment of the present application, a plurality of solder balls 12 are arranged in a rectangular inner ring, and since a ridge portion 121 is provided in the rectangular inner ring, the number of solder balls forming a longitudinal side 123 of the rectangular inner ring is reduced to five, and a lateral side 122 of the rectangular inner ring is kept to be formed by four solder balls 12. Compared with the arrangement of solder balls in the related art, in the embodiment of the present application, an area occupied by the plurality of solder balls 12 in the arrangement of solder balls where the ridge portion 121 is provided inside is smaller. However, in the arrangement of the solder balls in which the ridge portion 121 is provided, the ridge-shaped waveguide cavity technology is used, which ensures that the performance will not be reduced when the plurality of solder balls 12 are used for the radiation sheet 119 to transmit signals.

In an exemplary example, as shown in FIG. 3, the inner ring enclosed by the plurality of solder balls 12 is a rectangular inner ring having a ridge portion 121 therein. The rectangular inner ring includes two lateral sides 122, two longitudinal sides 123, and a ridge portion 121. Both the lateral sides 122 and the longitudinal sides 123 are formed by a plurality of solder balls 12 arranged in a straight line. The lateral side 122 is perpendicular to the longitudinal side 123. Two ends of one lateral side 122 are respectively connected to one end of one longitudinal side 123 and one end of the other longitudinal side 123, and two ends of the other lateral side 122 are respectively connected to the other end of the one longitudinal side 123 and the other end of the other longitudinal side 123. The ridge portion 121 is provided between the two lateral sides 122 and between the two longitudinal sides 123. The ridge portion 121 is provided on the inner side of the lateral side 122 and/or the longitudinal side 123. In this way, the ridge portion 121 protrudes inwardly from the rectangular ring enclosed by the lateral sides 122 and the longitudinal sides 123. The embodiment of the present application uses the ridge-shaped waveguide technology to reduce the area occupied by the plurality of solder balls 12 as a whole by reducing the size of the lateral side 122 and/or the longitudinal side 123 on the premise of ensuring transmission performance unchanged.

In an exemplary example, as shown in FIG. 3, one ridge portion 121 is provided, and the ridge portion 121 may be located in the middle of one longitudinal side 123 of the rectangular inner ring and away from the middle of the other longitudinal side 123 of the rectangular inner ring. In an exemplary example, one ridge portion 121 is provided, and the ridge portion 121 may be located in the middle of one lateral side 122 of the rectangular inner ring and away from the other lateral side 122 of the rectangular inner ring. In some embodiments, the ridge portion 121 is disposed in the middle of one side of the rectangular inner ring, and the area occupied by the plurality of solder balls 12 as a whole can be further reduced by reducing the size of the lateral side 122 and/or the longitudinal side 123 on the premise of ensuring transmission performance unchanged by using the ridge-shaped waveguide technology.

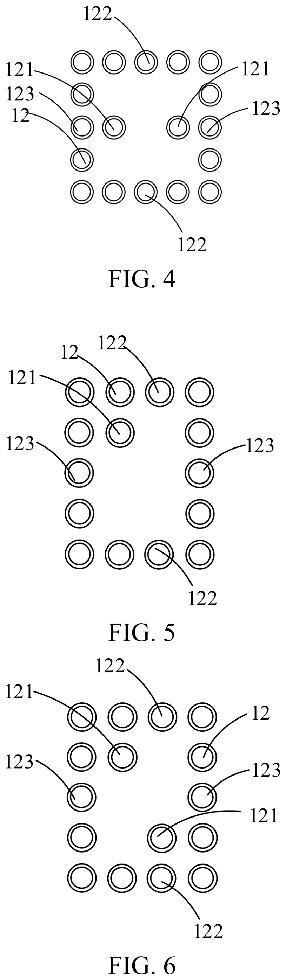

In an exemplary example, as shown in FIG. 4, two ridge portions 121 are provided, and the two ridge portions 121 are spaced apart, wherein one ridge portion 121 may be located in the middle of one longitudinal side 123 of the rectangular inner ring, and the other ridge portion 121 may be located in the middle of the other longitudinal side 123 of the rectangular inner ring. In an exemplary example, two ridge portions 121 are provided, and the two ridge portions 121 are spaced apart, wherein one ridge portion 121 may be located in the middle of one lateral side 122 of the rectangular inner ring, and the other ridge portion 121 may be located in the middle of the other lateral side 122 of the rectangular inner ring. In some embodiments, two ridge portions 121 are provided, and the two ridge portions 121 are respectively located in the middles of two opposite sides of the rectangular inner ring, and the area occupied by the plurality of solder balls 12 as a whole can be reduced by reducing the size of the lateral side 122 and/or the longitudinal side 123 on the premise of ensuring transmission performance unchanged by using the ridge-shaped waveguide technology.

In an exemplary example, as shown in FIG. 5, one ridge portion 121 is provided, the ridge portion 121 is disposed at one corner formed by the intersection of one lateral side 122 and one longitudinal side 123 of the rectangular inner ring. In some embodiments, the ridge portion 121 is positioned at one corner of the rectangular inner ring, and the area occupied by the plurality of solder balls 12 as a whole can be reduced by reducing the size of the lateral side 122 and/or the longitudinal side 123 on the premise of ensuring transmission performance unchanged by using the ridge-shaped waveguide technology.

In an exemplary example, as shown in FIG. 6, two ridge portions 121 are provided, one ridge portion 121 is provided in one corner formed by intersection of one lateral side 122 and one longitudinal side 123 of the rectangular inner ring, and the other ridge portion 121 is provided in one corner formed by intersection of the other lateral side 122 and the other longitudinal side 123 of the rectangular inner ring. The two ridge portions 121 are located at two opposite corners of the rectangular inner ring, respectively. In some embodiments, two ridge portions 121 are provided, and the two ridge portions 121 are respectively located at two opposite corners of the rectangular inner ring, and the area occupied by the plurality of solder balls 12 as a whole can be reduced by reducing the size of the lateral side 122 and/or the longitudinal side 123 on the premise of ensuring transmission performance unchanged by using the ridge-shaped waveguide technology.

In an exemplary example, the inner ring enclosed by the plurality of solder balls 12 is a circular ring or an elliptical ring inside which a ridge portion 121 is provided.

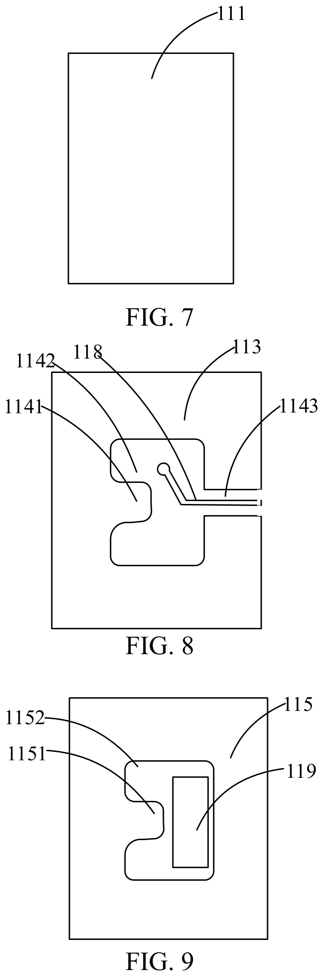

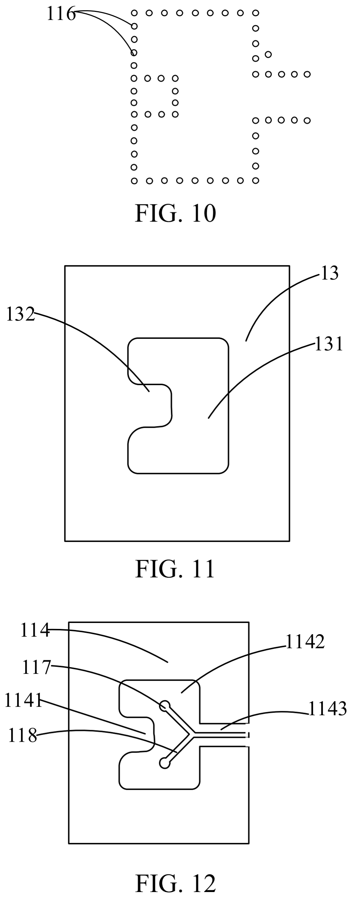

In an exemplary example, as shown in conjunction with FIGs. 9 and 11, the radio-frequency apparatus further includes a PCB board 13, waveguide holes 131 are respectively provided at positions corresponding to respective radiation sheets 119 on the PCB board 13, the packaging body is mounted on the PCB board 13, and a plurality of solder balls around the radiation sheet 119 corresponding to each waveguide hole 131 are also provided around the boundary of the waveguide hole into a ring.

The IC die can realize signal transmission between itself and the waveguide holes 131 of the PCB board 13 through the waveguide channel formed by the radiation sheet 119 and the plurality of solder balls 12, and a side of the PCB board 13 away from the packaging body is further provided with an antenna structure, and the signal is transmitted to the antenna structure via the waveguide hole 131, so that the connection between the waveguide hole and the antenna structure. The signal from the antenna structure can also be transmitted to the IC die via the waveguide hole 131, the waveguide channel, and the radiation sheet 119.

In an exemplary example, a shape of a cross section of the waveguide hole 131 is the same as a shape of an inner ring enclosed by the plurality of solder balls 12 around the radiation sheet. In this way, it is beneficial to further reducing the signal transmission loss and improving the signal transmission efficiency.

In an exemplary example, an inner wall of the waveguide hole 131 is provided with a protrusion rib 132, the protrusion rib 132 extends from one end to the other end of the waveguide hole 131, so that the cross section of the waveguide hole 131 is ridge-shaped. The number of protrusion ribs 132 is the same as the number of ridge portions 121. The protrusion ribs 132 and the ridge portions 121 are provided in one-to-one correspondence, and each ridge portion 121 is connected to one end of the protrusion rib 132, corresponding to the ridge portion, close to the packaging body 11.

In the embodiment of the present application, by providing the cross section of the waveguide hole 131 on the PCB board 13 into a ridge shape, the loss of the signal transmitted between the waveguide channel formed by the plurality of solder balls 12 and the waveguide hole 131 is effectively reduced, and the signal transmission efficiency is improved.

In an exemplary example, as shown in FIG. 1, the packaging body 11 may further include a first metal layer 111, a first insulating layer 112, a second metal layer 113, a second insulating layer 114, a third metal layer 115, a plurality of shielding metallization vias 116, and a conversion metallization via 117.

The first metal layer 111, the first insulating layer 112, the second metal layer 113, the second insulating layer 114, and the third metal layer 115 are stacked sequentially. Both the first insulating layer 112 and the second insulating layer 114 are made of an insulating material, the first insulating layer 112 supports the first metal layer 111 and the second metal layer 113, and the second insulating layer 114 supports the second metal layer 113 and the third metal layer 115.

As shown in FIG. 7, the first metal layer 111 serves as a metal ground layer. In an embodiment, in the RF region, the first metal layer 111 may be entirely made of metal and used as a reference ground for the third metal layer 115.

As shown in FIG. 8, the second metal layer 113 is provided with a RF trace 118, and each radiation sheet 119 is connected to the IC die through the RF trace 118.

In one embodiment, the radiation sheet 119 is disposed on the third metal layer 115, one end of the RF trace 118 is connected to the IC die, and the other end extends above the radiation sheet 119, such that a projection of the RF trace 118 on the third metal layer 115 is at least partially overlapped with the radiation sheet 119, so that a capacitor is formed between the radiation sheet 119 and the RF trace 118 to introduce capacitance characteristics.

As shown in FIGs. 1 and 2, the other end of the RF trace 118 is also connected to the radiation sheet 119 below the RF trace 118 through the conversion metallization via 117, and the RF trace 118 is connected to the radiation sheet 119 through the conversion metallization via 117 to introduce inductance characteristics. An extension direction of the conversion metallization via 117 is perpendicular to the third metal layer 115.

As shown in FIGs. 1, 2, and 10, the plurality of shielding metallization vias 116 are ground vias disposed around the radiation sheet 119 and the RF trace 118 for guiding RF signal propagation and preventing leakage. The shielding metallization via 116 extends from the first metal layer 111 to the third metal layer 115, and an extension direction of the shielding metallization via 116 is perpendicular to the third metal layer 115.

In the radio-frequency apparatus provided by one embodiment of the present application, on one hand, the capacitance characteristic structure of the capacitor is formed between the RF trace 118 arranged on the second metal layer 113 and the radiation sheet 119 arranged on the third metal layer 115, on the other hand, the inductance characteristic of the conversion structure is introduced through the conversion metallization via 117 provided between the second metal layer 113 and the third metal layer 115, and an equivalent circuit of the two constitutes a wideband resonance structure. The radio-frequency apparatus has the characteristics of simple structure, low loss, wide impedance bandwidth, and has good machinability and radio frequency performance.

In an exemplary example, as shown in FIG. 8, the second metal layer 113 is provided with a first hollowed-out region 1142 and a hollowed-out band 1143. The hollowed-out band 1143 extends outwardly from the first hollowed-out region 1142. The RF trace 118 is also arranged in the first hollowed-out region 1142 and the hollowed-out band 1143 in the second metal layer 113. The RF trace 118 extends along the hollowed-out band 1143 into the first hollowed-out region 1142. An end of the RF trace 118 away from the first hollowed-out region 1142 is electrically connected to the IC die. A plurality of shielding metallization vias 116 are distributed around the second hollowed-out region 1152 and the hollowed-out band 1143. In one embodiment, a RF reference ground is provided at the periphery of the first hollowed-out region 1142 and the hollowed-out band 1143.

In an exemplary example, as shown in FIG. 9, the third metal layer 115 is provided with a second hollowed-out region 1152. The second hollowed-out region 1152 is aligned with the first hollowed-out region 1142 on the second metal layer 113 in a direction perpendicular to the third metal layer 115. The radiation sheet 119 is disposed in the second hollowed-out region 1152.

In one exemplary example, the plurality of solder balls 12 are all connected to a surface of the third metal layer 115 away from the second metal layer 113. The plurality of solder balls 12 surround the second hollowed-out region 1152 of the third metal layer 115 and surround the periphery of the radiation sheet 119.

As shown in FIGs. 8 and 9, shapes of the first hollowed-out region 1142 of the second metal layer 113 and the second hollowed-out region 1152 of the third metal layer 115 are the same as the shape of the inner ring formed by the plurality of solder balls 12. The first hollowed-out region 1142 and the second hollowed-out region 1152 are aligned with each other in a direction perpendicular to the third metal layer 115.

An edge of the first hollowed-out region 1142 protrudes inwardly to form a first protrusion portion 1141. An edge of the second hollowed-out region 1152 protrudes inwardly to form a second protrusion portion 1151. The number of the first protrusion portions 1141 and the number of the second protrusion portions 1151 each is the same as the number of the ridge portions 121. The first protrusion portions 1141 and the second protrusion portions 1151 are provided in one-to-one correspondence, and each first protrusion portion 1141 is aligned with its corresponding second protrusion portion 1151 in a direction perpendicular to the third metal layer 115.

The second protrusion portions 1151 are provided in one-to-one correspondence with the ridge portions 121, and each ridge portion 121 is connected to the corresponding second protrusion portion 1151.

In the embodiment of the present application, the inner rings formed by the first hollowed-out region 1142, the second hollowed-out region 1152, and the plurality of solder balls 12 are all configured as ridge-shaped structures, and are aligned with each other in a direction perpendicular to the third metal layer 115, which is beneficial to improving signal transmission efficiency, reducing loss, and increasing bandwidth.

In an exemplary example, the RF trace 118 may include, but is not limited to, the following traces, such as a Substrate Integrated Waveguide (SIW), a Microstrip line (Microstrip), or a Stripline.

In one embodiment, the RF trace 118 is an exemplary Y-shaped trace as shown in FIG. 12. The RF trace 118 bifurcates in the second hollowed-out region 1152. The RF trace 118 includes two branches located in the second hollowed-out region 1152, and a conversion metallization via 117 is provided at one end of each branch close to the radiation sheet 119, respectively.

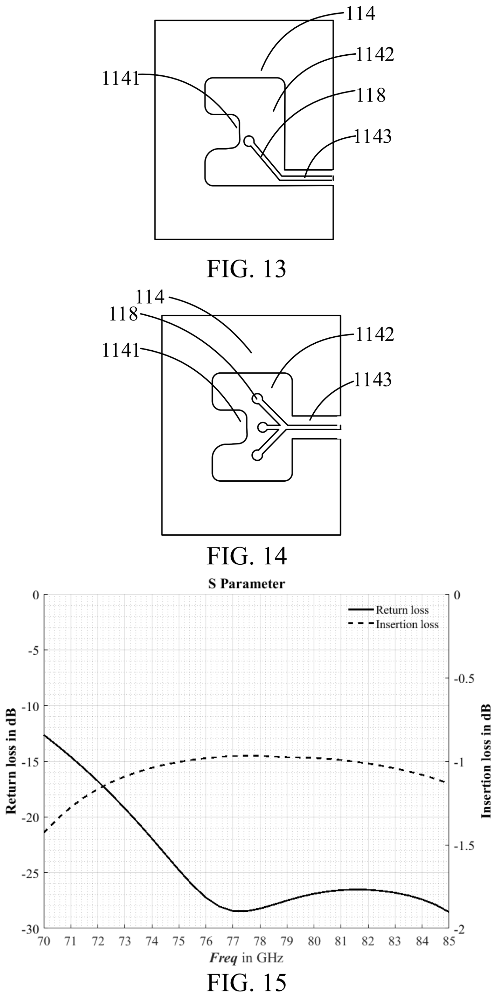

In one embodiment, as shown in FIGs. 8 and 13, the RF trace 118 is an exemplary single branch trace, that is, a half Y-shaped branch trace, and a conversion metallization via 117 is provided at one end of the branch close to the radiation sheet 119.

In some embodiments, a single branch RF trace 118 may be a straight trace, or a bending trace of another form.

In one embodiment, as shown in FIG. 14, the RF trace 118 is of an exemplary symmetrical trident type, including three branches located in the second hollowed-out region 1152, and a conversion metallization via 117 is provided at one end of each branch close to the radiation sheet 119. Compared with the single branch RF trace 118, the symmetrical multi-branch RF trace 118 has a better transmission efficiency.

In one exemplary example, a length L of overlap between the RF trace 118 and the radiation sheet 119 in space should be sufficiently long, so that a resonance circuit formed by the capacitance formed between the RF trace 118 and the radiation sheet 119 and the inductance introduced by the conversion metallization via 15 can form a wideband resonance structure. In one embodiment, a projection of the RF trace 118 on the third metal layer 115 has an overlapping length L with the radiation sheet 119, which is greater than or equal to one third of the length of the radiation sheet 119.

FIG. 15 is a schematic diagram of an RF performance waveform of the radio-frequency apparatus according to an embodiment of the present application. As shown in FIG. 15, the abscissa represents frequency (in GHz), a left ordinate represents return loss (in dB), and a right ordinate represents insertion loss (in dB). FIG. 15 shows the return loss and insertion loss in decibels (dB) across the frequency range of 70 to 85 GHz, wherein, the solid curve represents a return loss curve, and the dashed curve represents an insertion loss curve. The waveform curve shown in FIG. 15 shows the RF performance of the conversion structure from the IC die package to the waveguide in the vehicle millimeter wave radar frequency band, which realizes characteristics of high transmission efficiency, low loss and wide bandwidth in the whole frequency band, and ensures the RF performance.

An embodiment of the present application further provides a radar apparatus, including at least: the radio-frequency apparatus according to any one of the embodiments of the present application; an antenna radiation structure electrically connected with the radio-frequency apparatus for signal transmission. In one embodiment, the antenna radiation structure may be electrically connected to the PCB board 13.

Radiation on Package (RoP) technology will add a metal patch with radiation effect to transmit and receive signals during packaging. The radiation patch is surrounded by a ring of solder balls and is connected with the windowed PCB to form a transition structure with a metal cavity, which can transmit the RF signal in the package to the externally connected waveguide antenna.

In the related art, a rectangular window is provided on the PCB to serve as a waveguide channel for transmitting radio-frequency signals, which occupies a larger package size of the PCB.

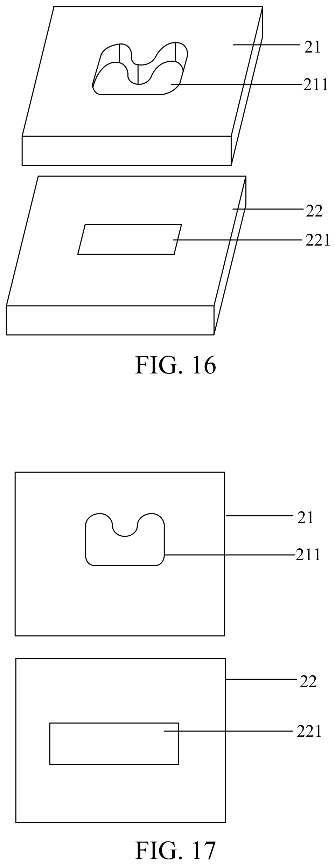

An embodiment of the present application relates to a radio-frequency transmission system. As shown in FIGs. 16 and 17, the radio-frequency transmission system includes: a PCB board 21 on which at least one first waveguide hole 211 is provided, and the first waveguide hole 211 is a ridge-shaped waveguide hole; a waveguide structure 22, which is provided with a second waveguide hole 221 at a position corresponding to each first waveguide hole 211 on an end face of the waveguide structure docked with the first waveguide hole 211, wherein the second waveguide hole 221 is a ridge-shaped waveguide hole or a rectangular waveguide hole (the rectangular waveguide hole is illustrated as an example in FIG. 16), and the first waveguide hole 211 communicates with the second waveguide hole 221 to form a channel for transmitting a radio-frequency signal.

In an exemplary embodiment, a chip packaging body may be mounted on the PCB board 21, and at least one signal transceiver may be provided on a side of the chip packaging body facing the PCB board 21, and each signal transceiver may be provided directly opposite to a first waveguide hole 211. The first waveguide hole 211 penetrates two opposite surfaces of the PCB board 21, and may be used to transmit the radio-frequency signal transmitted by the signal transceiver on the chip packaging body or the received radio-frequency signal via the first waveguide hole 211 directly opposite the signal transceiver to realize signal transmission and reception. In the embodiment of the present application, by providing the first waveguide hole 211 as a ridge-shaped waveguide hole, the package size occupied by the first waveguide hole 211 on the PCB board 21 is effectively reduced. In one embodiment, other regions of the PCB board 21 other than the first waveguide hole 211 may be also configured to lay traces and provide devices to realize other functions, and the present embodiment is not limited thereto.

A second waveguide hole 221 is provided at a position corresponding to each first waveguide hole 211 on an end face of the waveguide structure 22 docking each first waveguide hole 211, and the first waveguide hole 211 and the second waveguide hole 221 are docked to form a channel for transmitting a radio-frequency signal. The radio-frequency signal transmitted or received by the signal transceiver may be transmitted through the transmission channel. By providing the second waveguide hole 221 as a ridge-shaped waveguide hole or a rectangular waveguide hole (a rectangular waveguide hole is illustrated as an example in FIG. 16), the diversity of channels for transmitting the radio-frequency signal is enriched.

In some embodiments, the first waveguide hole 211 may be a single-ridge waveguide hole, as shown in FIG. 16.

In other embodiments, the second waveguide hole 221 may be a rectangular waveguide hole.

As shown in FIG. 16, a case where the first waveguide hole 211 is a single-ridge waveguide hole and the second waveguide hole 221 is a rectangular waveguide hole is shown. For the PCB board 21, the first waveguide hole 211 is designed as a single-ridge waveguide hole, which not only reduces an area occupied by the first waveguide hole 211 on the PCB board 21, but also reduces the process difficulty compared with the double-ridge waveguide hole. Since there is generally no special dimensional requirement for an externally connected waveguide structure 22 in the process, the most conventional rectangular waveguide hole may be opened as the second waveguide hole 221 to form the rectangular waveguide to be docked with the waveguide channel of the PCB board 21, which can further reduce the process difficulty.

In the radio-frequency transmission system provided by the embodiment of the present application, since the ridge-shaped waveguide hole is provided on the PCB board as the first waveguide hole, the occupied area of the waveguide structure on the PCB board is more greatly reduced than the traditional rectangular waveguide hole, and at the same time, the ridge-shaped waveguide hole or the rectangular waveguide hole on the waveguide structure is docked with the ridge-shaped waveguide hole on the waveguide structure to form a transmission channel of the radio-frequency signal, thus realizing the diversification of the transmission channel of the radio-frequency signal.

Implementation details of the radio-frequency transmission system of the present embodiment will be described in detail below, and the following contents are provided for convenience of understanding only, and are not necessary for implementing the present solution.

Compared with rectangular windowing, in the present embodiment, a ridge-shaped waveguide hole (including a single-ridge waveguide hole and a double-ridge waveguide hole) are made on the PCB board 21, which effectively reduces the package size and increases the isolation between channels. However, when the waveguide structure 22 is mounted on the PCB board 21, there is inevitably a gap between the first waveguide hole 211 and the second waveguide hole 221 due to the loose surface connection. When the RF signal leaks from the gap, the transmission efficiency of the RF signal in the channel will be reduced. In addition, the signal will be coupled to other channels through the gap, resulting in reduced isolation, thus seriously affecting the performance of the antenna module.

In order to effectively reduce the leakage of radio-frequency signals in the transmission channel from the gap, or entry of the free signals in the gap into the transmission channel, that is, to improve the signal isolation between the transmission channel and the outside, the present embodiment proposes an isolation structure.

That is, in some embodiments, an end face of the waveguide structure 22 docked with the PCB board 21 is provided with an isolation structure that prevents transmission of signals laterally along the end face.

In the present embodiment, the isolation structure may be composed of a plurality of protrusion structures provided on the above-mentioned end face of the waveguide structure 22, and a surface of the isolation structure may be made of metal. In the present embodiment, the shape, number, and arrangement of these protrusion structures are not limited, and the radiation signal free in the gap between the waveguide structure 22 and the docking surface of the PCB board 21 can be isolated to some extent by the isolation structure. Specific forms of the isolation structure will be described below with reference to various embodiments.

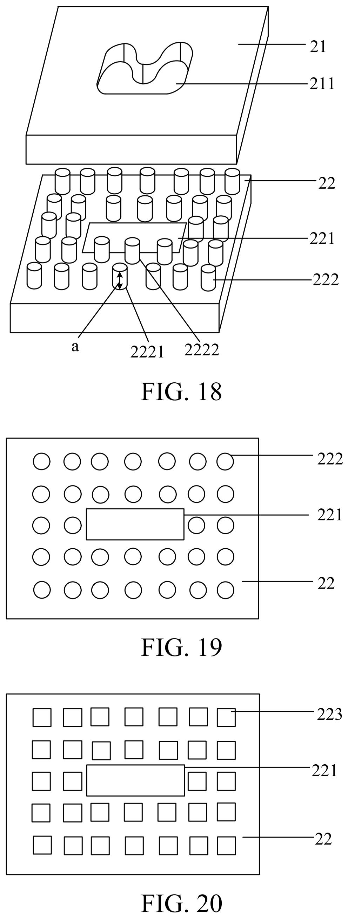

In some embodiments, as shown in FIGs. 18, 19, and 20, the isolation structure adopts an electromagnetic band gap structure, and the isolation structure includes a plurality of protrusion structures periodically arranged, and the protrusion structure is a metal structure or a structure plated with metal on its surface; the plurality of protrusion structures periodically arranged can prevent propagation of surface waves, thereby preventing the radio-frequency signal from leaking from the transmission channel to the outside; can also prevent the free radio-frequency signal in the gap of the surfaces where the PCB board 21 is docked with the waveguide structure 22 from entering an adjacent transmission channel, thereby realizing signal isolation between transmission channels.

In some embodiments, these protrusion structures may be cylindrical protrusion structures 222 as shown in FIGs. 18 and 19, or cuboid-shaped protrusion structures 223 as shown in FIG. 20; the shape of the cross-section of the protrusion structure is not limited, and may be adjusted according to specific needs. In one embodiment, the shapes of various protrusion structures may be the same or different, which is not limited.

In some embodiments, in the above periodically arranged protrusion structures, a height of the protrusion structures may be about 1/4 of the wavelength of the radio-frequency signal, preferably 1/4 of the wavelength; a distance between two adjacent protrusion structures is 1/6 wavelength to 1/2 wavelength of the radio-frequency signal, and the distance between the two protrusion structures here refers to a distance between centers of the two protrusion structures.

Specifically, as shown in FIG. 18, a plurality of cylinders are provided on the end face of the waveguide structure 22 docked with the PCB board 21. Taking two certain cylinders 2221 and 2222 as an example, the height a of the cylinders is about $\lambda/4$, and the distance between the two adjacent cylinders 2221 and 2222 is about $\lambda/4$, where $\lambda$ is the wavelength of the radio-frequency signal.

In some other embodiments, in order to simplify the isolation structure, the protrusion structures may be arranged only at positions on the edge of the second waveguide hole 221 where the field strength are strongest.

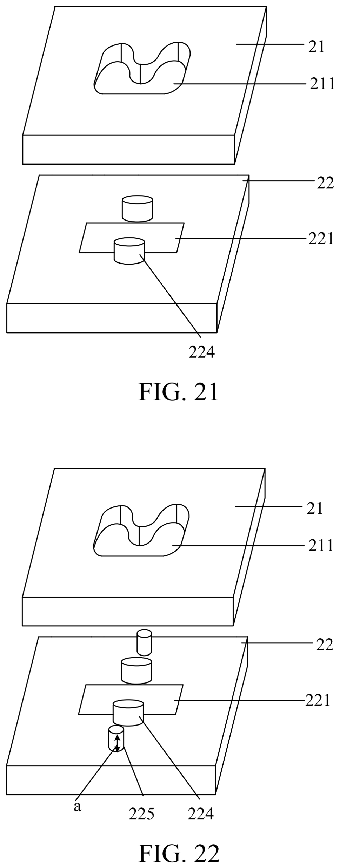

In an exemplary example, as shown in FIG. 21, the isolation structure may include a first protrusion structure 224 located at a strongest signal field region on the edge of the second waveguide hole 221. In one embodiment, the second waveguide hole 221 is rectangular, and the middle positions of the two long sides of the rectangular waveguide hole are the strongest signal field regions, and a first protrusion structure 224 is respectively provided at each position of the two positions.

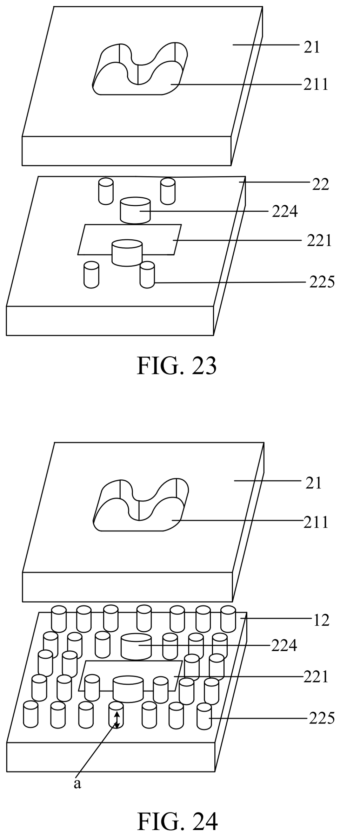

In an exemplary example, as shown in FIG. 22, the isolation structure at least includes a first protrusion structure 224 located at the strongest signal field region on the edge of each second waveguide hole 221, and at least one second protrusion structure 225 surrounding the first protrusion structure. In one embodiment, when the second waveguide hole 221 is a rectangular waveguide hole, the middle positions of the two long sides of the rectangular waveguide hole are the strongest signal field regions, and a first protrusion structure 224 is respectively provided at each position of the two positions, and a second protrusion structure 225 may be provided around each one of the first protrusion structures 224. In one embodiment, as shown in FIG. 23, when the second waveguide hole 221 is a rectangular waveguide hole, the middle positions of the two long sides of the rectangular waveguide hole are the strongest signal field regions, and a first protrusion structure 224 is respectively provided at each one of the two positions, and two second protrusion structures 225 may be provided around each one of the first protrusion structures 224.

In one embodiment, the height of the first protrusion structure 224 described above is about 1/4 $\lambda$, preferably 1/4 $\lambda$, and $\lambda$ is the wavelength of the radio-frequency signal.

In one embodiment, a cross-sectional diameter of the first protrusion structure 224 described above is about 1/4 $\lambda$, preferably 1/4 $\lambda$, and $\lambda$ is the wavelength of the radio-frequency signal.

In one embodiment, a lateral distance between the first protrusion structure 224 described above and an adjacent second protrusion structure 225 is 1/6 $\lambda$ to 1/2 $\lambda$, and $\lambda$ is the wavelength of the radio-frequency signal.

In the embodiment of the present application, the region between the first protrusion structure 224 and the second protrusion structure 225 forms a strong field confinement region to prevent electromagnetic waves from escaping from the region; when the protrusion structure in the embodiment of the present application is arranged on two sides of a position of the waveguide channel where the edge field strength is strongest, the main energy leakage in the channel is prevented. The diameter of the first protrusion structure 224 is about $\lambda/4$, and the docking surface between the PCB board 21 and the waveguide structure 22 is metal. When there is a gap between the layer of metal and the top of the first protrusion structure 224, capacitive reactance will be introduced, and it will act with the inductive reactance introduced by the first protrusion structure 224 itself to form resonance, which not only ensures the impedance matching between the first waveguide hole 211 and the second waveguide hole 221, but also prevents the signal from leaking through the gap.

In some embodiments, in order to achieve better radio frequency transmission performance, the cross-sectional diameter of the first protrusion structure 224 may be set to be greater than or equal to the cross-sectional diameter of the second protrusion structure 225.

In some embodiments, a projection of the first protrusion structure 224 on the PCB board 21 is located outside the first waveguide hole 221, so that the top of the first protrusion structure 224 is directly opposite to the region of the PCB board 21 where there is no first waveguide hole, thereby forming a gap.

In some embodiments, a projection of the second protrusion structure 225 on the PCB board 21 is located outside the first waveguide hole 221, so that the top of the second protrusion structure 225 can be directly opposite to the region of the PCB board 21 where there is no first waveguide hole, thereby forming a gap.

In some embodiments, the height of the second protrusion structure 225 is 1/4 of the wavelength of the radio-frequency signal, and/or the diameter of the top of the second protrusion structure 225 is 1/4 of the wavelength of the radio-frequency signal, and/or the distance between two adjacent second protrusion structures 225 is 1/6 to 1/2 of the wavelength of the radio-frequency signal. These dimensions may be configured to form a structure such as the cylinder 2221 and the cylinder 2222 described above between the two adjacent second protrusion structures 225 as much as possible, so as to realize the isolation of free signals in the gap. The specific principle refers to the foregoing contents, and will not be repeatedly described here.

In some embodiments, a plurality of second protrusion structures 225 are provided around each first protrusion structure 224, and all the second protrusion structures 225 and respective first protrusion structures 224 are arranged in an array on the above-described end face for further enhancing the isolation effect.

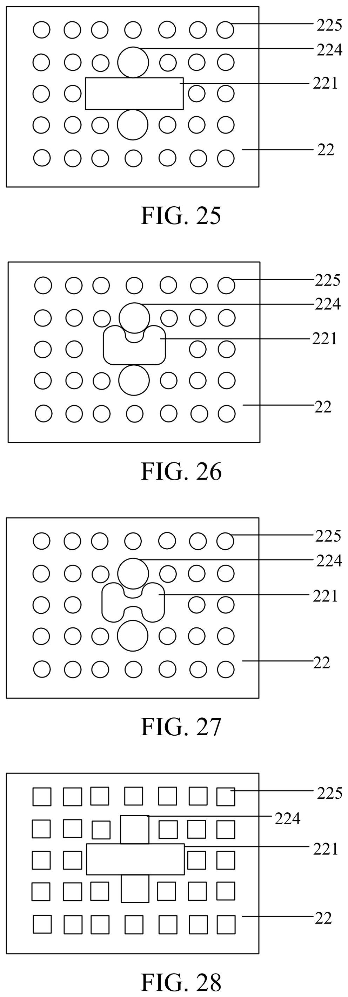

For example, in FIGs. 24-28, all of the first protrusion structures 224 and all of the second protrusion structures 225 as a whole are still substantially arranged in an array. The differences between FIGs. 24 to 28 are only that the graphic structures of the first protrusion structure 224 and the second protrusion structure 225 are different: in FIGs. 24 to 27, they are cylindrical, while in FIG. 28, they are cuboid-shaped; the structures of the second waveguide holes 221 are different: it is a rectangular waveguide hole in FIGs. 24, 25, and 28, a single-ridge-shaped waveguide hole in FIG. 26, and a double-ridge-shaped waveguide hole in FIG. 27.

In some embodiments, the first and second protrusion structures 224, 225 are in a shape of at least one of a cuboid, a cylinder and a frustum.

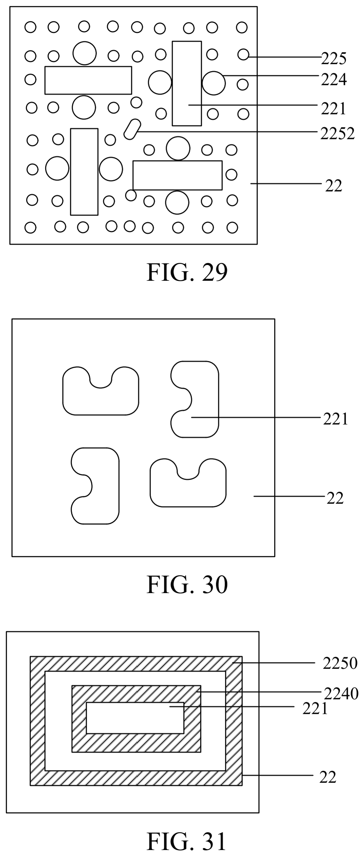

In some practical application scenarios, as shown in FIG. 29, for provision of the relative positional relationship between the second waveguide holes 221 and the isolation structures, a cross arrangement as shown in FIG. 29 may also be adopted, that is, various second waveguide holes 221 may be arranged after being rotated at different angles according to a certain rule. Correspondingly, the first protrusion structure 224 may still be located in the strongest signal field region around the second waveguide hole 221, and the second protrusion structure 225 is arranged around the first protrusion structure 224. In some cases, due to the limitation of space area, some special-shaped second protrusion structures 225 may also be provided, such as the second protrusion structure 2252 in FIG. 29.

As shown in FIG. 30, it is a schematic diagram of a cross arrangement of a plurality of single-ridge-shaped waveguide holes when the second waveguide hole 221 is a single-ridge-shaped waveguide hole.

As shown in FIG. 31, the isolation structure is formed by improving the first protrusion structure 224 and the second protrusion structure 225 in the present embodiment, that is, the first protrusion structures 224 at the same distance interval from the second waveguide hole 221 are communicated to form an annular boss 2240; similarly, the second protrusion structures 225 at the same distance interval from the second waveguide hole 221 are communicated to form an annular boss 2250. In this way, the complexity of the casting can be reduced.

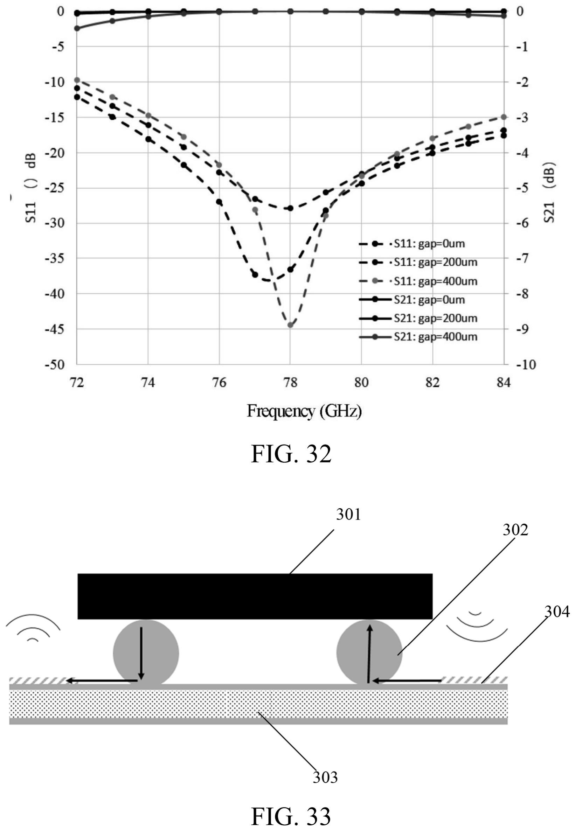

As shown in FIG. 32, it is a transmission performance diagram of the above-mentioned radio-frequency transmission system of the present embodiment. It can be seen from FIG. 32 that when the gap between the PCB board 21 and the waveguide structure 22 is 0 um, 200 um, and 400 um, respectively, corresponding transmission coefficients and reflection coefficients are in a good range.

The radio-frequency transmission system provided by the embodiment of the present application includes a PCB board 21 and a waveguide structure 22, and at least one first waveguide hole 211 is provided on the PCB board 21, and the first waveguide hole 211 is a ridge-shaped waveguide hole. On the end face of the waveguide structure 22 docked with the first waveguide hole 211, a second waveguide hole 221 is provided at a position corresponding to each first waveguide hole 211, and the second waveguide hole 221 is a ridge-shaped waveguide hole or a rectangular waveguide hole, and the radio-frequency signal is transmitted in a channel formed by the first waveguide hole 211 and the second waveguide hole 221. Since the ridge-shaped waveguide hole is provided on the PCB board 21 as the first waveguide hole 211, the package size occupied by the waveguide structure on the PCB board 21 is more greatly reduced compared with the traditional rectangular waveguide hole. In addition, the ridge-shaped waveguide hole or the rectangular waveguide hole on the waveguide structure 22 is docked with the ridge-shaped waveguide hole on the waveguide structure to form a transmission channel of the radio-frequency signal, thus realizing the diversification of the transmission channel of the radio-frequency signal.

Another embodiment of the present application relates to a radio-frequency system, including: a chip package structure, and the radio-frequency transmission system according to any one of the embodiments of the present application;.

A surface of the chip package structure is provided with at least one signal transceiver; one side of the chip package structure provided with the signal transceiver is mounted on the PCB board of the radio-frequency transmission system, and signal transceivers and the first waveguide holes on the PCB board are provided in one-to-one correspondence respectively.

In one embodiment, the signal transceiver is connected to an IC die within the chip package structure.

In one embodiment, a plurality of solder balls are arranged around the signal transceiver to form a waveguide channel for signal transmission, one side of the chip package structure provided with the signal transceiver is mounted to the PCB board of the radio-frequency transmission system through the solder balls, and signal transceivers and the first waveguide holes on the PCB board are provided in one-to-one correspondence, and a plurality of solder balls are also arranged around the first waveguide hole into a ring.

The radio-frequency system further includes an antenna structure disposed at an end of the second waveguide hole away from the PCB board.

In one embodiment, the waveguide channel enclosed by a plurality of solder balls, the first waveguide hole, and the second waveguide hole together constitute a radio-frequency signal transmission channel between the signal transceiver and the antenna structure.

In the traditional packaging technology, radio-frequency signals are generated by IC and connected to an external circuit through a package. After fanout, the radio-frequency signal is transmitted to the planar waveguide in the PCB through the solder balls to realize the signal path. The radio-frequency signal is transmitted to the antenna through the planar waveguide feeder on the PCB board. Because the planar waveguide has large dielectric loss and radiation loss, these losses are proportional to the length of the feeder. Such radio-frequency module, which uses a planar waveguide to feed the antenna, has large losses; moreover, since the antenna is designed on the PCB board, once the chip is soldered to the PCB board, the antenna cannot be replaced.

As shown in FIG. 33, the radio-frequency signal is generated by an IC in the chip 301 and transmitted to an external circuit through a package. After the radio-frequency signal is fanout through the package substrate, it passes through the solder ball 302 and a planar waveguide in the PCB board 303, thereby realizing a signal path, and then it is transmitted to the antenna 304 on the PCB board 303 via the planar waveguide feeder line. That is, the transmission process of the radio-frequency signal from the IC to the antenna 304 is completed in the planar waveguide mode, and the antenna 304 is also fixedly disposed on the surface on a side of the PCB board 303 facing the chip 301. Because the planar waveguide has large dielectric loss and radiation loss, which are proportional to the length of the feeder, the system loss of the RF module that uses the planar waveguide to feed the antenna is large; and the antenna is designed on the PCB board, once the chip is soldered to the PCB board, the antenna cannot be replaced.

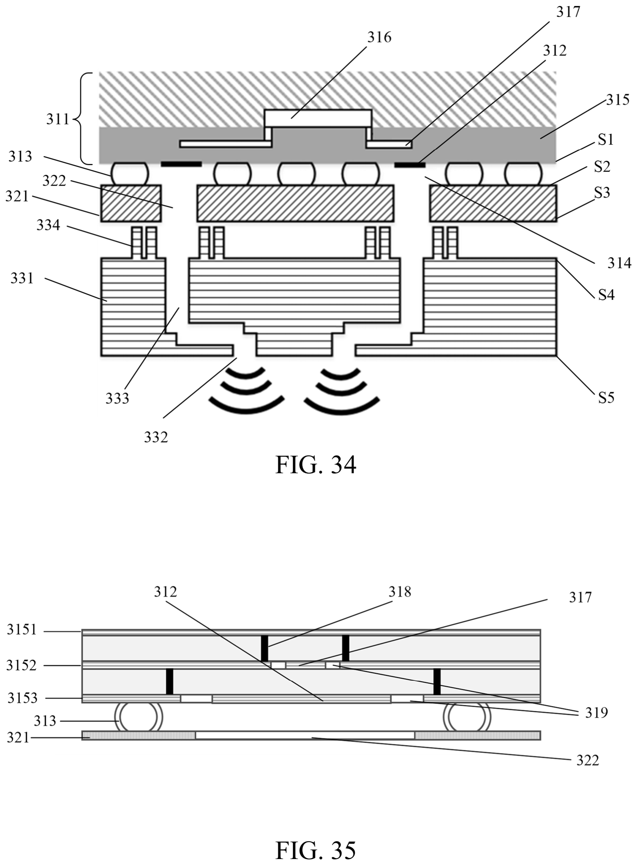

An embodiment of the present application relates to a radio-frequency module, as shown in FIG. 34, including: a chip packaging body 311, a PCB board 321, and a waveguide antenna 331.

A first surface S1 of the chip packaging body 311 is provided with at least one radiation portion 312, the first surface S1 is provided with a plurality of solder balls 313, and the plurality of solder balls 313 are disposed around the radiation portion 312 to form a first waveguide channel 314.

In an exemplary example, the first surface S1 is a surface of the chip packaging body 311 facing the PCB board 321, and the first surface S1 is provided with a radiation portion 312, and the radiation portion 312 is used for externally transmitting and receiving radio-frequency signals. In one embodiment, the radiation portion 312 may be a radiation patch. In one embodiment, the radiation portion 312 is not limited to a radiation patch, but may also be other forms of radiation structures. In one embodiment, the shape of the radiation patch may be at least one of a rectangle, a diamond, and a butterfly, or any other pattern shape. In one embodiment, the radiation patches may be disposed in a metal layer of the integrated circuit in a patterning form.

In an exemplary example, a plurality of radiation portions 312 may be provided, and a plurality of solder balls 313 may be provided around each radiation portion 312. It should be noted that the solder balls 313 may also be replaced by conductive adhesive and other means. In one embodiment, a shape of the solder ball 313 may be any shape such as a spherical shape, a columnar shape, or a block shape. In one embodiment, the solder ball 313 may be a metal solder ball, and the material thereof may be gold, copper, copper nickel gold, tin, or the like.

In FIGs. 34 and 35, the space surrounded by the plurality of solder balls 313 is a waveguide channel for transmitting a radio-frequency signal, which is referred to as a first waveguide channel 314.

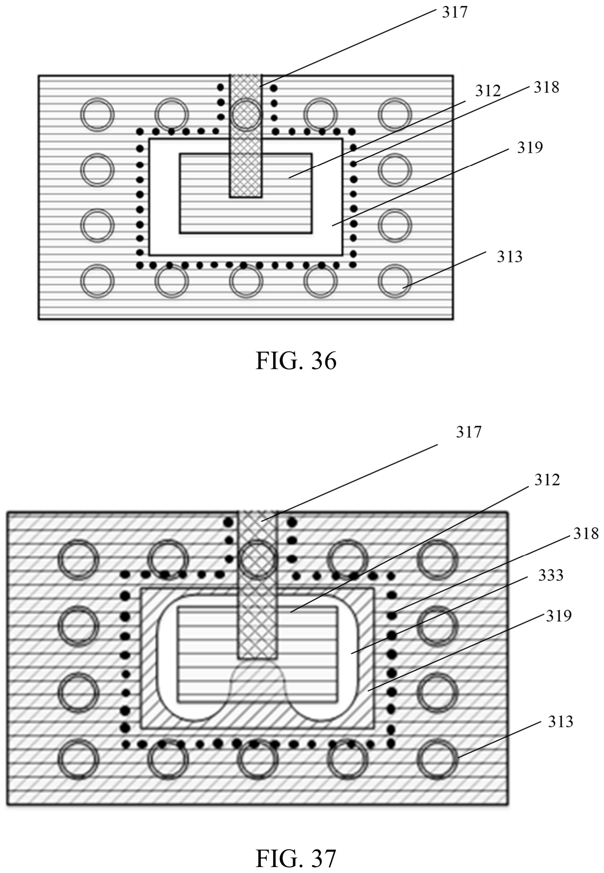

In FIGs. 34 and 36, the radio-frequency signal inside the chip packaging body 311 may be radiated to the first waveguide channel 314 through the radiation portion 312, and one end of the solder ball 313 provided around the radiation portion 312 is connected to the chip packaging body 311 and the other end thereof is connected to the PCB board 321, so that the closed rectangular ring enclosed can confine electromagnetic waves in a single signal transmission channel, effectively preventing signal leakage between channels, reducing crosstalk between channels, and improving isolation.

In FIG. 34, the PCB board 321 has a second surface S2 and a third surface S3 which are opposite, the second surface S2 is docked with the first surface S1 of the chip packaging body 311, and a second waveguide channel 322 is provided on a position of the PCB board 321 corresponding to the first waveguide channel 314.

In an exemplary example, the second surface S2 and the third surface S3 are two surfaces parallel to various metal layers in the PCB board 321, wherein the second surface S2 is in direct contact with the solder balls 313 to achieve docking of the PCB board 321 and the chip packaging body 311. Through the soldering action of the solder balls 313, the second surface S2 and the first surface S1 may be connected by the solder balls to achieve stable docking. A second waveguide channel 322 penetrating the second surface S2 and the third surface S3 is provided at a position of the docked second surface S2 corresponding to each first waveguide channel 314. In one embodiment, the cross-section of the second waveguide channel 322 may be single-ridge-shaped, or may be rectangular, double-ridge-shaped or another structure.

By providing the cross section of the second waveguide channel 322 as single-ridge-shaped, the area occupied by the second waveguide channel 322 on the PCB board 321 can be effectively reduced compared with the conventional rectangular waveguide. Since the channel port dimensions of the first waveguide channel 314 enclosed by the solder balls 313 and the second waveguide channel 322 are consistent, the provision of the single-ridge-shaped waveguide channel can reduce the size of the chip packaging body by reducing the size of the first waveguide channel 314.

In FIG. 34, the waveguide antenna 331 has a fourth surface S4 and a fifth surface S5 which are opposite, the fourth surface S4 is docked with the third surface S3, the fifth surface S5 is provided with at least one antenna unit 332, and a third waveguide channel 333 is provided within the waveguide antenna 331.

In an exemplary example, the fourth surface S4 is a surface of the waveguide antenna 331 docked with the third surface S3 of the PCB board 321, and the fifth surface S5 is a surface of the waveguide antenna 331 away from the PCB board 321 when the waveguide antenna 331 is docked with the PCB board 321. Antenna units 332 are provided on the fifth surface S5, the antenna units 332 are configured to transmitting and receiving radio-frequency signals, each antenna unit 332 may include a plurality of radiation slots (e.g., may be a waveguide slot antenna) for transmitting and/or receiving radio-frequency signals. A plurality of third waveguide channels 333 are provided in the waveguide antenna 331, and one end of each third waveguide channel 333 is in communication with one second waveguide channel 322, respectively, and the other end thereof is in communication with one antenna unit 332, respectively.

In FIG. 34, the radio-frequency signal generated in the chip packaging body 311 is coupled to the radiation portion 312 and then radiated outwardly, and is transmitted to the antenna unit 332 through a radio-frequency signal transmission channel composed of the first waveguide channel 314, the second waveguide channel 322, and the third waveguide channel 333 in communication sequentially, and then the antenna unit 332 radiates it as a radio signal to the outside. On the contrary, after a radio signal is received by the antenna unit 332, the radio signal is transmitted to the radiation portion 312 through the radio-frequency signal transmission channel composed of the third waveguide channel 333, the second waveguide channel 322, and the first waveguide channel 314, and the radiation portion 312 couples the received signal to the inside of the chip packaging body 311 for processing.

In an exemplary example, the radio-frequency signal transmission channel can realize the connection between the chip packaging body 311, the PCB board 321 and the waveguide antenna 331 and the matching of radio-frequency signals, and the waveguide antenna 331 can be directly connected with the chip packaging body 311 without other conversion structures, thereby reducing the design load degree; compared with the planar waveguide, the use of the waveguide antenna 331 effectively reduces the feeder loss and improves the output performance of the radio-frequency module.

In an exemplary example, the PCB board 321 is located between the chip packaging body 311 and the waveguide antenna 331, In addition to being used to realize the connection between the chip packaging body 311 and the waveguide antenna 331, the PCB board may also carry other peripheral circuits, and the peripheral circuits and the second waveguide channel 322 may be isolated from each other by providing gaps in a non-metallic region.

In some embodiments, as shown in FIG. 34, the chip packaging body 311 at least includes a substrate 315 and an IC die 316. A surface of the substrate 315 away from the IC 316 is the first surface S1, and an RF trace 317 is provided inside the substrate, and a radio-frequency signal is transmitted to the radiation portion 312 through the RF trace 317.

In an exemplary example, the substrate 315 both plays the role of a carrier for the IC die 316 and plays the role of a medium for transmitting radio-frequency signals generated by the IC die 316 to the radiation portion 312. By providing the RF trace 317 inside the substrate, the radio-frequency signals generated by the IC die 316 can be fanout into a plurality of radiation portions 312 that are distributed relatively scattered.

In some embodiments, as shown in FIGs. 35 to 37, the substrate 315 at least includes a metal ground layer 3151, a feeder layer 3152, and a patch layer 3153; the RF trace 317 is provided in the feeder layer 3151, and the radiation portion 312 is provided in the patch layer 3153, wherein the radio-frequency signal is coupled to the radiation portion 312 through the RF trace 317.

FIG. 35 is a top view of the feeder layer 3152 and the patch layer 3153, and the viewing angle is from the inside of the chip packaging body 311 to the outside of the chip packaging body 311. In FIGs. 34 and 35, the radio-frequency signal generated by the IC die 316 is transmitted to the feeder layer 3152 by a via 318 and coupled into the radiation portion 312 of the patch layer 3153 at the end of the RF trace 317. The feeder layer 3152 and the patch layer 3153 have opposite rectangular windows 319, and the sizes of the two rectangular windows 19 may be the same or different. The RF trace 317 and the radiation portion 312 are respectively located in the windows 319 of the metal layers to which they belong, and the outside of the windows 319 is GND. The gap from by the rectangular windows 319 may insulate the RF trace 317 and the radiation portions 312 from the external GND. Vias 318 arranged at equal intervals may also be provided at the inner side of the GND close to the rectangular window 319. These vias 318 connect the GND of the feeder layer 3152 and the GND of the patch layer 3153. A ring of grounded solder balls 313 below the patch layer 3153 are soldered below a ring of GND on the periphery of the rectangular window 319, and the lower surface of the solder balls are soldered to the PCB board 321.

In FIGs. 36 to 37, when the radiation portion 312 radiates the millimeter wave signal obtained from the RF trace 317 in a coupled manner, the closed first waveguide channel 314 enclosed by the solder balls 313 surrounding the radiation portion 312 can confine the electromagnetic wave in a single signal transmission channel, thereby reducing crosstalk between channels and improving isolation. The cavity enclosed by the GND of the patch layer 3153 in the substrate 315, the solder balls 313, and the metal on the upper surface of the PCB board 321 are positioned between the radiation portion 312 and the single-ridge-shaped window (the second waveguide channel 322) to play the roles of mode matching and impedance matching, so that the transmission mode of the electromagnetic wave can be well converted from the transmission mode of the planar microstrip line to the waveguide transmission mode.

FIG. 37 is a top view of connections of the feeder layer 3152, the patch layer 3153 and the PCB board 321, and the viewing angle is from the inside of the chip packaging body 311 to the outside of the chip packaging body 311. In FIGs. 35 and 37, a single-ridge window is opened on the PCB board 321 as the second waveguide channel 322, and its position is directly opposite to the position of the radiation portion 312 in the chip packaging body. The side wall and the upper and lower surfaces of the single-ridge window are plated with a conductive metal layer, and the metal plated on the upper and lower surfaces extends outward from the edge of the single-ridge window to cover the soldering region of the solder balls 313.

In the actual process design, the other side of the metal ground layer 3151 in the substrate 315 may not be provided with other metal layers, and the IC die 316 may be directly provided above the metal ground layer 3151, and the metal ground layer 3151 plays a role of isolation between the IC die 316 and the feeder layer 3152; other metal layers may also be provided on the other side of the metal ground layer 3151 in the substrate 315, and the IC die 316 may be directly disposed above the other metal layers, and the metal ground layer 3151 plays a role of isolation between the other metal layers and the feeder layer 3152. In the metal ground layer 3151, the feeder layer 3152, and the patch layer 3153, a dielectric layer is provided between every two adjacent layers, and connections may be achieved between various metal layers by providing vias 18.

In some embodiments, the second waveguide channels 333 are arranged in an array, and the long sides of two adjacent second waveguide channels 333 are perpendicular to each other.

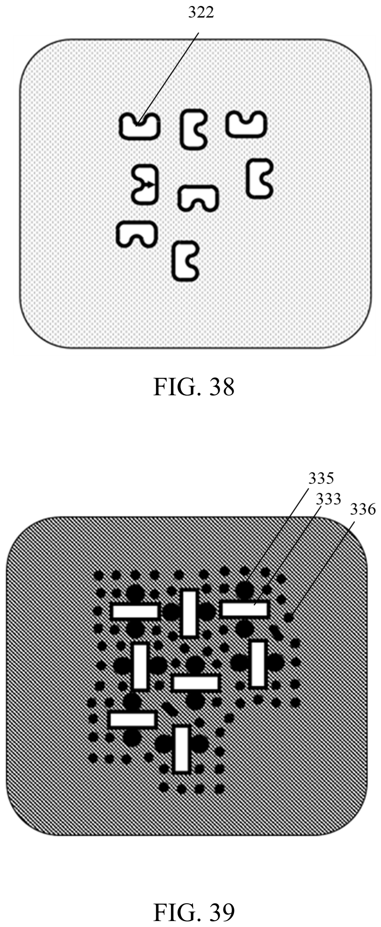

As shown in FIG. 38, a port layout with respect to the second waveguide channel 333 in a 4T4R radio-frequency module (4 modules for transmitting and 4 modules for receiving) is shown. The viewing angle of the drawing is viewed from the third surface S3 toward the second surface S2 of the PCB board 321. The cross section of the second waveguide channel 333 in FIG. 38 is single-ridge-shaped (for example, it may be a single-ridge-shaped waveguide), and a direction of the electric field when the electromagnetic wave propagates therein is mainly perpendicular to the long side where the ridge is located. Through the port arrangement shown in the present example, the polarizations between adjacent ports are ensured to be perpendicular to each other, thereby reducing the signal crosstalk problem at the ports. In addition, each of the second waveguide channels 333 may appear smoothly.

In some embodiments, as shown in FIG. 34, an isolation structure 334 is further provided on the fourth surface S4, and the isolation structure 334 includes a plurality of protrusion structures periodically arranged.

When the waveguide antenna 331 is assembled on the PCB board 321, the surfaces of the waveguide antenna and the PCB board are not tightly connected due to processing and assembly errors, so there is inevitably a gap. When the radio-frequency signal leaks from the gap, the transmission efficiency of the radio-frequency signal in the channel will be reduced, and in addition, the signal will be coupled to other channels through the gap to form channel crosstalk, resulting in a reduction in isolation and seriously affecting the performance of the radio-frequency module.

Therefore, the embodiment of the present application proposes that the isolation structure 334 is provided on the fourth surface S4 to prevent the lateral transmission of signals along the surface of the gap. In one embodiment, the isolation structure 334 may be composed of a plurality of protrusion structures disposed on the fourth surface S4. In the present embodiment, the shape, number, and arrangement of these protrusion structures are not limited, and the protrusion structures may be cylinders, cuboids, hexagonal prisms, or the like. In one embodiment, the protrusion structure is a metal structure or a structure plated with metal on the surface. In the present embodiment, the plurality of protrusion structures periodically arranged prevent the propagation of surface waves, thereby preventing the leakage of radio-frequency signals from the transmission channel to the outside, and also preventing the free radio-frequency signals in the gap of the end face where the PCB board 321 is docked with the waveguide antenna 331 from entering the adjacent transmission channels, thereby realizing signal isolation between transmission channels. In some embodiments, the waveguide antenna 331 may be connected to the PCB board 321 by fasteners such as screws and bolts.

In some embodiments, as shown in FIG. 39, the protrusion structure included in the radio-frequency module of the present application includes a plurality of first protrusion structures 335 and a plurality of second protrusion structures 336, and the cross-sectional area of the first protrusion structure 335 is greater than or equal to the cross-sectional area of the second protrusion structure 336.

FIG. 39 is a top view of the third waveguide channel 333 on the fourth surface S4 of the waveguide antenna 331, its view is from the fourth surface S4 toward the inside of the waveguide antenna 331. In the present example, a rectangular waveguide antenna is used, which requires less computer numerical control (CNC) process or plastic injection electroplating process, and a port shape presented on the fourth surface S4 is rectangular. The periphery of the port may be surrounded by non-uniform protrusion structures.

When one port at one end of the third waveguide channel 333 for docking the second waveguide channel 322 is rectangular (i.e., a rectangular waveguide hole), the middle positions of the two long sides of the rectangular waveguide hole are the strongest signal field regions, and the signal field intensities extending outward from the middle positions gradually decrease, and protrusion structures with different cross-sectional areas can be provided in the signal field regions of different intensities to achieve differential isolations. In the present embodiment, two types of protrusion structures, that is, the first protrusion structures 335 and the second protrusion structures 336, are provided on the fourth surface S4, wherein a cross-sectional area of the first protrusion structures 335 is greater than or equal to a cross-sectional area of the second protrusion structures 336.

In some embodiments, a plurality of first protrusion structures 335 are located on the centerline of long sides of the third waveguide channel 333.

In some embodiments, a plurality of second protrusion structures 336 are disposed around a first protrusion structure 335.

In some embodiments, the gap between the upper surfaces of the first protrusion structure 335 and the second protrusion structure 336 and the third surface S3 does not exceed 400 micrometers ($\mu$m).

In FIG. 39, thick cylinders (taking this example as an example, operating at the 77 GHz millimeter-wave frequency band for vehicles, and the diameter and height of the cylinder are about 1 mm) as the first protrusion structures 335 are symmetrically placed at the center positions of the long sides of the rectangular waveguide hole of the third waveguide channel 333. When the electromagnetic wave is transmitted from the second waveguide channel 322 of the PCB board 321 to the third waveguide channel 333, the thick cylinder may maintain the normal transmission of the electromagnetic wave and ensure good matching. The present embodiment allows a certain gap between the waveguide antenna 331 and the PCB board 321, which is a distance between the upper surface of the protrusion structure and the third surface, and this gap is about 0 to 400 $\mu$m for the millimeter wave frequency band for vehicles. Thin cylinders as second protrusion structures 336 are distributed around the thick cylinders to block fine energy escaping from the gap. There are no strict requirements for the dimensions of these thin cylinders, for example, the height of the thin cylinder may be consistent with that of the thick cylinder, and the diameter of the thin cylinder and the gap from the surrounding cylinders may be within half a wavelength. In one embodiment, a distance between the thick cylinder and the center of the long side of the rectangular waveguide hole is kept within $\pm$ 100 $\mu$m to improve the consistency between channels.

In some embodiments, the height of the first and second protrusion structures 335, 336 is $\frac{1}{4}\lambda$ , wherein, $\lambda$ is an operating wavelength of the radio-frequency signal.

In some embodiments, the second protrusion structure 336 has a diameter of [1/10 $\lambda$, 1/3 $\lambda$], wherein, $\lambda$ is the operating wavelength of the radio-frequency signal.

In some embodiments, the distance between the first protrusion structure 335 and an adjacent second protrusion structure 336 is [1/6 $\lambda$, 1/2 $\lambda$], wherein, $\lambda$ is the operating wavelength of the radio-frequency signal.

In some embodiments, as shown in FIG. 8, the third waveguide channel 33 is in communication with the antenna unit 33 from an end of the wide side surface of the antenna unit 32 or a middle position of the wide side surface.

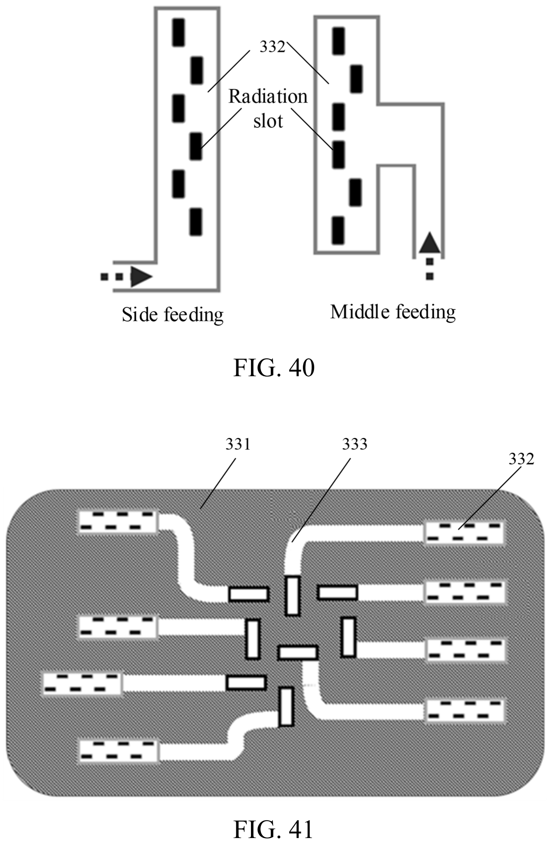

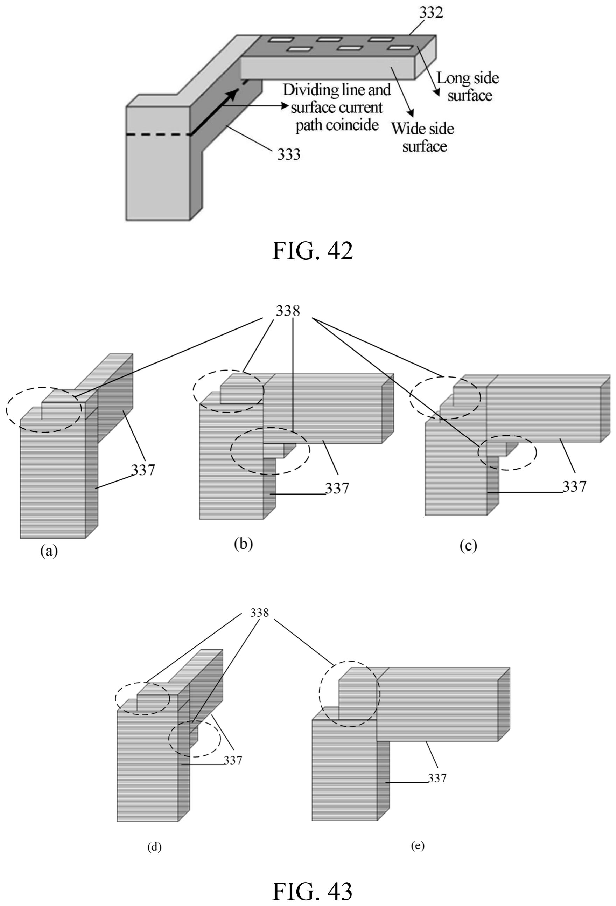

As shown in conjunction with FIG. 42, the cross section of the waveguide cavity of the antenna unit 332 is rectangular, where a side surface on which the long side of the rectangle is located is called the long side surface, and a side surface on which the wide side of the rectangle is located is called the wide side surface. In FIG. 40, slots for radiating radio-frequency signals outwardly are provided on the long side surface. FIG. 40 shows two feeding modes of the waveguide antenna: the left figure shows that the radio-frequency signal in the third waveguide channel 333 is fed into the antenna unit 332 from one end of the wide side surface of the antenna unit 332, which is called side feeding; the right figure shows that the radio-frequency signal in the third waveguide channel 333 is fed into the antenna unit 332 from the middle position of the wide side surface of the antenna unit 332, which is called middle feeding.

FIG. 41 is a layout diagram of an array formed by antenna units 332 and feed lines constituted by the third waveguide channels 333 in the waveguide antenna 331.

In some embodiments, as shown in FIG. 42, the waveguide antenna 331 includes two spliced parts (an upper half and a lower half divided along a dividing line), the spliced surface of the two parts is parallel to a direction of a surface current of the radio-frequency signal, and a path of the surface current is located on the spliced surface.

In some embodiments, as shown in FIG. 42, the waveguide antenna 31 is designed as a double-layer structure, which is divided into upper and lower parts from the dividing line in the figure. For the rectangular waveguide in the figure, the path of the surface current inside the waveguide antenna parallel to an extension direction of the waveguide coincides with the dividing line. When the connection between the upper and lower structures is not tightly connected, the division mode in FIG. 42 can effectively reduce the energy leakage.

In some embodiments, as shown in FIG. 43, the third waveguide channel 333 includes at least two cavity segments 337 having a rectangular cross-section, and a stepped transition structure 338 is provided at the junction between adjacent cavity segments 337.

For example, in FIG. 43, two cavity segments 337 from bottom to top are included in (a) and (d), wherein the cavity segment 337 located at the top transfers out from the long side surface of the cavity segment 337 located at the bottom, also referred to as the long side transferring out, and two cavity segments 337 from bottom to top are included in (b), (c) and (e), wherein the cavity segment 337 located at the top transfers out from the wide side of the cavity segment 337 located at the bottom, also referred to as the wide side transferring out.

In one embodiment, the stepped transition structure 338 may be further designed at the junction between adjacent cavity segments 337 described above, i.e. at the transferring-out position. By reasonably designing the recesses and protruding steps to form the stepped transition structure 338, better impedance matching can be achieved, electromagnetic wave reflection at turning discontinuities can be reduced.

In one embodiment, the stepped transition structure 338 may be a single-stepped structure as shown in (a), (b), (d), and (e) of FIG. 43, or may be a multi-stepped structure as shown in (c) of FIG. 43, and the number of layers of the stepped structure is not limited in the present embodiment.

The radio-frequency module in the present embodiment has the following advantages over the conventional radio-frequency module.

In the packaging design of the chip packaging body 311, the RF trace 317 is fanout inside the substrate 315 and the radiation portion 312 is provided outside the chip packaging body 311; the radiation portion 312 can couple the radio-frequency signal from the chip packaging body to the external waveguide antenna, which improves the flexibility of chip and antenna design and is more conducive to realizing miniaturization design.

In order to prevent leakage between channels, the periphery of the radiation portion 312 is enclosed by solder balls 313 to form a first waveguide channel 314. One end of the solder ball 313 is connected to the chip packaging body 311, and the other end of the solder ball is soldered to the PCB board 321, thereby realizing channel docking.

A single-ridge-shaped window is excavated in the corresponding region surrounded by solder balls in the PCB board 321 as the second waveguide channel 322 to realize the connection between the chip packaging body 311, the PCB board 321 and the waveguide antenna 331 and the matching of radio-frequency signals.

The waveguide antenna 331 adopts a two-layer structure to facilitate processing, the upper layer includes the antenna unit 332 and a part of the RF trace 317, and the lower layer includes a part of the RF trace 317 and an interface between the RF trace 317 docked with the first waveguide channel 314. The dividing line of the two-layer structure is parallel to the direction of the surface current inside the rectangular waveguide, which effectively reduces the energy leakage at the dividing line.

The use of the waveguide antenna 331 can reduce the feeder loss and increase the output power of the radar.

In short, the radio-frequency module provided by the above embodiment of the present application reduces the size of the chip packaging body, and has low cost, high power, good isolation and robustness.

Another embodiment of the present application further provides a radar, including: the radio-frequency module as in any one of the embodiments.

In an exemplary example, the radar is configured to transmit an electromagnetic wave signal via a transmitting antenna based on a reference frequency, receiving an echo formed by reflection of a target object using a receiving antenna, and perform down-conversion processing based on the transmitted radio-frequency signal to generate and output an intermediate frequency signal; and the radar is also configured to convert the intermediate frequency signal into a digital signal and then perform signal processing.

In some embodiments, the electromagnetic wave signal is a frequency modulated continuous wave signal, and the frequency modulated continuous wave signal is a millimeter wave signal, so that the electronic apparatus equipped with the radar can be applied to fields such as autonomous driving, industrial automation, smart home appliances, and security inspection.

In some embodiments, the radar may be an AiP millimeter wave radar chip integrated with an antenna.

In an embodiment, the radar may generate a chirp signal in a preset continuous frequency modulation mode; the chirp signal is processed by frequency doubling, a radio-frequency transmission signal is obtained, and is fed to the transmitting antenna, and a corresponding detection signal wave is transmitted. When the detection signal wave is reflected by an object, an echo signal wave is formed. The echo signal wave is converted into a radio frequency receiving signal by a receiving antenna. The radar uses the radio-frequency transmission signal to down-convert and filter the radio-frequency received signal, and then performs analog-to-digital conversion processing to output a baseband digital signal representing a frequency difference between the detection signal wave and the echo signal wave. Then measurement information is extracted from the baseband digital signal by signal processing, and the measurement data is output. Herein, the signal processing includes: carrying out digital signal processing and calculation such as processing in phase, in frequency, or in time domain, etc., on at least one signal to be processed provided by at least one receiving antenna. The measurement data includes at least one of the following: distance data for indicating a relative distance of the at least one detected obstacle; velocity data for indicating a relative velocity of the at least one detected obstacle; and angle data for indicating a relative angle of the at least one detected obstacle, etc.

In some embodiments, an embodiment of the present disclosure further provides an electronic device including the aforementioned radar.

In some embodiments, the electronic device includes: a device body; and an electronic component such as a radar of the above embodiment provided on the device body. In one embodiment, the device body is a structure that carries a radio device and is in signal connection with the radio device. In some embodiments, the radio device achieves functions such as target detection and/or communication within the range of beam scanning by transmitting and/or receiving the radio signal phase-shifted by the phaser, so as to provide detected target information and/or communication information to the device body, and further assist or even control the operation of the device body.

In some embodiments, the above electronic device containing the device body and the above-mentioned at least one radio device may be a component and product applied to a field, such as smart houses, transportation, smart homes, consumer electronics, monitoring, industrial automation, in-cabin detection and health care. For example, the device body may be a smart transportation device (such as an automobile, bicycle, motorcycle, ship, subway, train, etc.), a security device (such as a camera), a liquid level/flow rate detection device, a smart wearable device (such as a bracelet, glasses, etc.), a smart home device (such as a sweeping robot, a door lock, a television, an air conditioner, a smart light, etc.), various communication devices (such as a mobile phone, a tablet computer, etc.), as well as a road gate, a smart traffic light, a smart sign, a traffic camera and various industrial mechanical arms (or robots), etc. The device body may be an instrument for detecting vital signs parameters and a device equipped with the instrument, such as a device for detection in automobile cabins, a device for indoor personnel monitoring, an intelligent medical device, a consumer electronic device, etc.

**Claims**

1. A radio-frequency apparatus, comprising a packaging body in which an Integrated Circuit (IC) die is packaged; a surface of the packaging body is provided with at least one radiation portion, and the at least one radiation portion is connected to the IC die to perform a signal transmission; a plurality of solder balls respectively disposed around a circumference of the at least one radiation portion, are further provided on the surface of the packaging body, and the plurality of solder balls constitute a waveguide channel for the at least one radiation portion to perform the signal transmission; an inner ring enclosed by the plurality of solder balls comprises a ridge portion protruding inwards.

2. The radio-frequency apparatus according to claim 1, further comprising a Printed Circuit Board (PCB); waveguide holes are respectively provided on the PCB at positions corresponding to respective radiation portions, the packaging body is mounted on the PCB, and a plurality of solder balls are arranged around a boundary of a waveguide hole into a ring.

3. The radio-frequency apparatus according to claim 2, wherein a shape of a cross section of the waveguide hole is the same as a shape of an inner ring enclosed by a plurality of solder balls around the radiation portion.

4. The radio-frequency apparatus according to claim 1, 2 or 3, wherein the inner ring is a rectangular ring in which the ridge portion is provided, a circular ring in which the ridge portion is provided, or an elliptical ring in which the ridge portion is provided.

5. The radio-frequency apparatus according to claim 1 or 2, wherein the inner ring is a rectangular ring in which the ridge portion is provided;

   there is one ridge portion; and the ridge portion is located at a middle of one side or a corner of the rectangular inner ring; or
   there are two ridge portions, and the two ridge portions are respectively located at middles of two opposite sides or two opposite corners of the rectangular inner ring.

6. A radio-frequency transmission system, comprising:

   a Printed Circuit Board (PCB) having a second surface and a third surface which are opposite, wherein at least one first waveguide hole is provided on the PCB, and the at least one first waveguide hole is a ridge-shaped waveguide hole;
   a waveguide structure having a fourth surface and a fifth surface which are opposite, wherein on the fourth surface, a second waveguide hole is provided at a position corresponding to each first waveguide hole, and the first waveguide hole is in communication with the second waveguide hole to form a channel for transmitting a radio-frequency signal.

7. The radio-frequency transmission system according to claim 6, wherein the second waveguide hole is a ridge-shaped waveguide hole or a rectangular waveguide hole.

8. The radio-frequency transmission system according to claim 6, wherein the ridge-shaped waveguide hole is a single-ridge waveguide hole or a double-ridge waveguide hole.

9. The radio-frequency transmission system according to claim 6, wherein the fourth surface is docked with the PCB, and an isolation structure is provided on the fourth surface.

10. The radio-frequency transmission system according to claim 9, wherein the isolation structure comprises a plurality of protrusion structures which are periodically arranged.

11. The radio-frequency transmission system according to claim 10, wherein a height of a protrusion structure is 1/4 wavelength of the radio-frequency signal, and a distance between two adjacent protrusion structures is 1/6 wavelength to 1/2 wavelength of the radio-frequency signal.

12. The radio-frequency transmission system according to claim 9 or 10, wherein the isolation structure comprises first protrusion structures at strongest signal field regions at edges of respective second waveguide holes;
the isolation structure further comprises at least one second protrusion structure disposed around a first protrusion structure, and the first protrusion structure has a cross-sectional diameter greater than or equal to a cross-sectional diameter of the second protrusion structure.

13. The radio-frequency transmission system according to claim 12, wherein a height of the second protrusion structure is 1/4 wavelength of the radio-frequency signal, and a diameter of the second protrusion structure is 1/10 wavelength to 1/3 wavelength of the radio-frequency signal.

14. The radio-frequency transmission system according to claim 12, wherein a gap between upper surfaces of the first protrusion structure and the second protrusion structure and the third surface does not exceed 400 $\mu$m.

15. The radio-frequency transmission system according to claim 12, wherein a distance between the first protrusion structure and an adjacent second protrusion structure is [1/6 $\lambda$, 1/2 $\lambda$], wherein $\lambda$ is an operating wavelength of the radio-frequency signal.

16. The radio-frequency transmission system according to claim 12, wherein the first protrusion structure and the second protrusion structure are in a shape of at least one of a cuboid, a cylinder and a frustum.

17. The radio-frequency transmission system according to claim 6, wherein at least one antenna unit is provided on the fifth surface, and the second waveguide hole is in communication with the antenna unit from an end of a wide side surface of the antenna unit or a middle position of the wide side surface.

18. The radio-frequency transmission system according to claim 17, wherein the second waveguide hole comprises two cavity segments which have rectangular cross-sections, and a stepped transition structure is provided at a junction between adjacent cavity segments.

19. The radio-frequency transmission system according to any one of claims 6 to 18, wherein the second waveguide holes are arranged in an array, and long sides of two adjacent second waveguide holes are perpendicular to each other.

20. The radio-frequency transmission system according to any one of claims 6 to 18, wherein the antenna unit comprises a plurality of radiation slots for transmitting and/or receiving the radio-frequency signal.

21. A radio-frequency system, comprising: a packaging body, and the radio-frequency transmission system of any one of claims 6 to 20;

at least one radiation portion is provided on a first surface of the packaging body, a plurality of solder balls are provided on the first surface, and the plurality of solder balls are disposed around the radiation portion to form a first waveguide channel;
the first surface of the packaging body is mounted on the second surface of the PCB, and radiation portions are disposed in one-to-one correspondence with first waveguide holes, respectively.

22. The radio-frequency system according to claim 21, the packaging body comprising a substrate and an Integrated Circuit (IC)die;
a surface of the substrate away from the IC die is the first surface, a radio frequency RF trace is provided inside the substrate, and the radio-frequency signal is transmitted to the radiation portion via the RF trace.

23. The radio-frequency system according to claim 22, wherein the substrate comprises a metal ground layer, a feeder layer, a patch layer;
the RF trace is disposed in the feeder layer, and the radiation portion is disposed in the patch layer; the radio-frequency signal is coupled to the radiation portion through the RF trace.

24. A radar, comprising the radio-frequency apparatus of any one of claims 1 to 5, or the radio-frequency transmission system of any one of claims 6 to 20, or the radio-frequency system of any one of claims 21 to 23.

**25.** An electronic device, comprising the radar according to claim 24.

FIG. 1

FIG. 2

FIG. 3

FIG. 3a

FIG. 4

FIG. 5

FIG. 6

FIG. 7

FIG. 8

FIG. 9

116

FIG. 10

132

13

131

FIG. 11

114

1142

117

1141

1143

118

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32

FIG. 33

FIG. 34

FIG. 35

317

312 318

319

313

FIG. 36

317

312

318

333

319

313

FIG. 37

322

FIG. 38

335
333
336

FIG. 39

332

Radiation slot

Side feeding

Middle feeding

FIG. 40

331    333    332

FIG. 41

332

Dividing line and
surface current
path coincide

Long side
surface

Wide side
surface

333

## FIG. 42

338

337

(a)

338

337

337

(b)

(c)

338

337

337

(d)

(e)

## FIG. 43

## INTERNATIONAL SEARCH REPORT

| International application No. |
|---|
| **PCT/CN2024/114349** |

| A. | CLASSIFICATION OF SUBJECT MATTER |
|---|---|

H01L 23/66(2006.01)i; H01L 23/31(2006.01)i; H01Q 1/22(2006.01)i; H01P 3/123(2006.01)i

According to International Patent Classification (IPC) or to both national classification and IPC

| B. | FIELDS SEARCHED |
|---|---|

Minimum documentation searched (classification system followed by classification symbols)

IPC: H01L 23/-, H01Q 1/-, H01P 3/-

Documentation searched other than minimum documentation to the extent that such documents are included in the fields searched

Electronic data base consulted during the international search (name of data base and, where practicable, search terms used)

CNTXT, CNABS, ENTXT, ENTXTC, DWPI, CNKI, IEEE: 封装, 发射, 辐射, 射频, 雷达, 印刷电路板, 印制电路板, 印刷线路板, 脊波导, 凸缘波导, 波导过渡, H形波导, 焊球, 凸块, 围绕, 环绕, 口, 孔, 通道, 天线, 凸起, 尺寸, 直径, LoP, RoP, package, radiation, launch, RF, radar, PCB, ridge?, waveguide, H shaped, guide transition, BGA, ball, solder, bump, around, opening, channel, antenna, convex, size, diameter

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 221125931 U (CALTERAH SEMICONDUCTOR TECHNOLOGY (SHANGHAI) CO., LTD.) 11 June 2024 (2024-06-11) description, paragraphs 40-86, and figures 1-15 | 1-5, 24-25 |
| PX | WO 2023215263 A1 (TEXAS INSTRUMENTS INC.) 09 November 2023 (2023-11-09) description, paragraphs 18-53, and figures 1A-13 | 6-8, 19, 21-25 |
| Y | CN 113812044 A (TEXAS INSTRUMENTS INC.) 17 December 2021 (2021-12-17) description, paragraphs 1 and 19-29, and figures 3-6B | 1-5, 21-25 |
| Y | CN 105680133 A (THE 10TH RESEARCH INSTITUTE OF CHINA ELETRONICS TECHNOLOGY GROUP CORP.) 15 June 2016 (2016-06-15) description, paragraphs 10 and 16-18, and figures 1-2 | 1-5, 24-25 |
| X | WO 2022184835 A1 (HUBER+SUHNER AG) 09 September 2022 (2022-09-09) description, page 6, lines 17-22 and page 25, line 2 to page 37, line 8, and figures 1-26 | 6-10, 17-20, 24-25 |
| Y | WO 2022184835 A1 (HUBER+SUHNER AG) 09 September 2022 (2022-09-09) description, paragraphs 98-142, and figures 1-26 | 11-16, 19-25 |

| ☑ | Further documents are listed in the continuation of Box C. | ☑ | See patent family annex. |
|---|---|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **08 November 2024** | **13 November 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2024/114349** |

### C.    DOCUMENTS CONSIDERED TO BE RELEVANT

| Category* | Citation of document, with indication, where appropriate, of the relevant passages | Relevant to claim No. |
|---|---|---|
| Y | CN 116779557 A (CALTERAH SEMICONDUCTOR TECHNOLOGY (SHANGHAI) CO., LTD.) 19 September 2023 (2023-09-19)<br>description, paragraphs 41-62, and figures 8-12C | 11-16, 19-25 |
| A | CN 102144289 A (MITSUBISHI ELECTRIC CORP.) 03 August 2011 (2011-08-03)<br>entire document | 1-25 |
| A | CN 108987866 A (NIDEC CORP. et al.) 11 December 2018 (2018-12-11)<br>entire document | 1-25 |
| A | CN 116454622 A (BEIJING INSTITUTE OF TECHNOLOGY, CHONGQING INNOVATION CENTER et al.) 18 July 2023 (2023-07-18)<br>entire document | 1-25 |
| A | CN 110800155 A (GAPWAVES AB) 14 February 2020 (2020-02-14)<br>entire document | 1-25 |

Form PCT/ISA/210 (second sheet) (July 2022)

# EP 4 708 361 A1

International application No.

**PCT/CN2024/114349**

| Patent document cited in search report | | | Publication date (day/month/year) | Patent family member(s) | | | Publication date (day/month/year) |
|---|---|---|---|---|---|---|---|
| CN | 221125931 | U | 11 June 2024 | None | | | |
| WO | 2023215263 | A1 | 09 November 2023 | US | 2023352841 | A1 | 02 November 2023 |
| CN | 113812044 | A | 17 December 2021 | KR | 20220005583 | A | 13 January 2022 |
| | | | | US | 2024235010 | A1 | 11 July 2024 |
| | | | | WO | 2020231905 | A1 | 19 November 2020 |
| | | | | US | 2020365971 | A1 | 19 November 2020 |
| | | | | US | 11196146 | B2 | 07 December 2021 |
| | | | | US | 2022052440 | A1 | 17 February 2022 |
| | | | | US | 11955698 | B2 | 09 April 2024 |
| | | | | JP | 2022533614 | A | 25 July 2022 |
| | | | | EP | 3970237 | A1 | 23 March 2022 |
| | | | | EP | 3970237 | A4 | 13 July 2022 |
| CN | 105680133 | A | 15 June 2016 | CN | 105680133 | B | 10 August 2018 |
| WO | 2022184835 | A1 | 09 September 2022 | US | 2024136723 | A1 | 25 April 2024 |
| | | | | US | 2024235038 | A9 | 11 July 2024 |
| | | | | EP | 4305710 | A1 | 17 January 2024 |
| | | | | JP | 2024507854 | A | 21 February 2024 |
| | | | | KR | 20230156086 | A | 13 November 2023 |
| | | | | CN | 116868445A 20231010 | A | 10 October 2023 |
| CN | 116779557 | A | 19 September 2023 | CN | 116779557 | B | 27 September 2024 |
| CN | 102144289 | A | 03 August 2011 | JP | 2011155287 | A | 11 August 2011 |
| | | | | JP | 5517982 | B2 | 11 June 2014 |
| | | | | EP | 2333828 | A1 | 15 June 2011 |
| | | | | EP | 2333828 | A4 | 18 July 2012 |
| | | | | EP | 2333828 | B1 | 20 November 2019 |
| | | | | JP | 5371997 | B2 | 18 December 2013 |
| | | | | JP | 2016197882 | A | 24 November 2016 |
| | | | | JP | 6180592 | B2 | 16 August 2017 |
| | | | | WO | 2010026990 | A1 | 11 March 2010 |
| | | | | US | 2011175793 | A1 | 21 July 2011 |
| | | | | US | 9433080 | B2 | 30 August 2016 |
| | | | | EP | 3598484 | A1 | 22 January 2020 |
| | | | | EP | 3598484 | B1 | 05 May 2021 |
| | | | | JP | 2013165273 | A | 22 August 2013 |
| | | | | JP | 5519815 | B2 | 11 June 2014 |
| | | | | JP | 2014187369 | A | 02 October 2014 |
| | | | | JP | 5775194 | B2 | 09 September 2015 |
| | | | | JP | 2015167422 | A | 24 September 2015 |
| | | | | JP | 5960886 | B2 | 02 August 2016 |
| | | | | US | 2015257254 | A1 | 10 September 2015 |
| | | | | US | 9648725 | B2 | 09 May 2017 |
| | | | | US | 2011163919 | A1 | 07 July 2011 |
| | | | | US | 9070961 | B2 | 30 June 2015 |
| CN | 108987866 | A | 11 December 2018 | US | 2018351261 | A1 | 06 December 2018 |
| | | | | JP | 2018207487 | A | 27 December 2018 |
| CN | 116454622 | A | 18 July 2023 | None | | | |
| CN | 110800155 | A | 14 February 2020 | WO | 2019022651 | A1 | 31 January 2019 |
| | | | | EP | 3659207 | A1 | 03 June 2020 |

Form PCT/ISA/210 (patent family annex) (July 2022)

INTERNATIONAL SEARCH REPORT
Information on patent family members

International application No.

**PCT/CN2024/114349**

| Patent document cited in search report | Publication date (day/month/year) | Patent family member(s) | | Publication date (day/month/year) |
|---|---|---|---|---|
| | | JP 2020532891 | A | 12 November 2020 |
| | | US 2020168974 | A1 | 28 May 2020 |
| | | KR 20200028460 | A | 16 March 2020 |

Form PCT/ISA/210 (patent family annex) (July 2022)

**REFERENCES CITED IN THE DESCRIPTION**

**Patent documents cited in the description**

- CN 202322672173
- CN 202323391601
- CN 202410566287